(19) Europäisches Patentamt
European Patent Office
Office européen des brevets

(11) **EP 4 478 398 A1**

(12) **EUROPEAN PATENT APPLICATION**
published in accordance with Art. 153(4) EPC

(43) Date of publication:
**18.12.2024 Bulletin 2024/51**

(21) Application number: **23752592.8**

(22) Date of filing: **12.01.2023**

(51) International Patent Classification (IPC):
***H01L 21/027*** *(2006.01)* ***B29C 59/02*** *(2006.01)*

(52) Cooperative Patent Classification (CPC):
**B29C 59/02; H01L 21/027**

(86) International application number:
**PCT/JP2023/000600**

(87) International publication number:
**WO 2023/153123 (17.08.2023 Gazette 2023/33)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **09.02.2022 JP 2022018847**

(71) Applicant: **CANON KABUSHIKI KAISHA**
**Tokyo 146-8501 (JP)**

(72) Inventors:
- **ITO, Yuto**
  **Tokyo 146-8501 (JP)**
- **ITO, Toshiki**
  **Tokyo 146-8501 (JP)**
- **KAWATA, Isao**
  **Tokyo 146-8501 (JP)**

(74) Representative: **Canon Europe Limited**
**European Intellectual Property Group**
**4 Roundwood Avenue**
**Stockley Park**
**Uxbridge UB11 1AF (GB)**

(54) **FILM FORMATION METHOD AND ARTICLE MANUFACTURING METHOD**

(57) A film forming method includes an arranging step of arranging a curable composition on a base material, a contact step of bringing the curable composition into contact with a film forming region of a mold after the arranging step, a curing step of curing the curable composition after the contact step, and a separation step of separating the curable composition and the mold after the curing step, wherein in the contact step, a gas that fills a space between the base material and the mold exists, a solubility coefficient of the gas to the curable composition is not less than 0.5 $kg/m^3 \cdot atm$ and not more than 10 $kg/m^3 \cdot atm$, and an average liquid film thickness that is a value obtained by dividing a volume of the curable composition by an area of the film forming region is not less than 70 nm.

F I G. 1

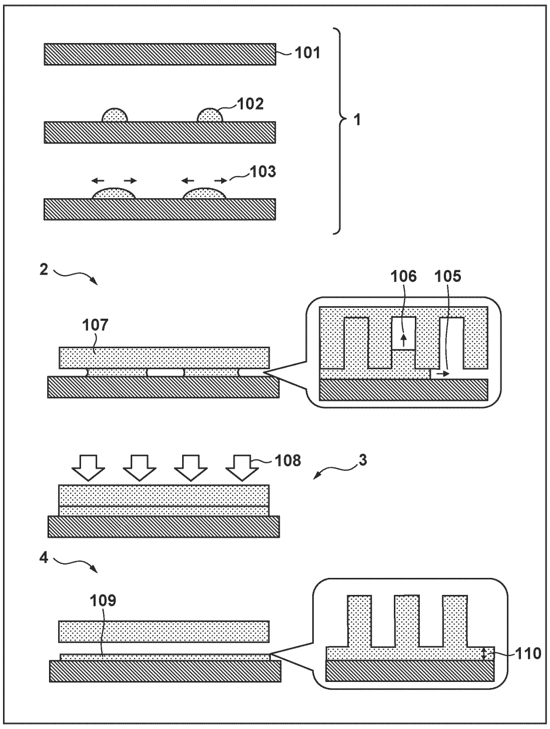


EP 4 478 398 A1

## Description

TECHNICAL FIELD

The present invention relates to a film forming method and an article manufacturing method.

BACKGROUND ART

A demand for miniaturization of semiconductor devices and MEMS is increasing, and a photonanoimprint technique is attracting attention as a microfabrication technique. In this photonanoimprint technique, a mold on the surface of which a fine pattern of concave and convex portions is formed is pressed against a substrate (wafer), and the curable composition is cured in this state, thereby transferring the pattern having concave and convex portions of the mold onto the cured film of the curable composition, and forming the pattern on the substrate. The photonanoimprint technique can form a fine structure on the order of a few nanometers on a substrate.

An example of a film forming method using the photonanoimprint technique will be explained below. First, a liquid curable composition is discretely dropped in a pattern formation region on a substrate. The droplets of the curable composition dropped in the pattern formation region spread on the substrate. This phenomenon can be called prespread. Then, a mold having a pattern is pressed against the curable composition on the substrate.

Consequently, the droplets of the curable composition spread to the whole area of the gap between the substrate and the mold by the capillary action. This phenomenon can be called spread. The curable composition is also filled in the concave portions of the pattern of the mold by the capillary action. This filling phenomenon can be called filling. The time until the completion of spread and filling can be called a filling time. After the filling of the curable composition is completed, the curable composition is irradiated with light and cured. After that, the mold is removed from the cured curable composition. By performing these steps, the mold pattern is transferred to the curable composition on the substrate, and a pattern of the curable composition is formed.

A photolithography step of fabricating a semiconductor device requires planarization of a substrate as well. For example, in an extreme ultraviolet exposure technique (EUV) as a photolithography technique attracting attention in recent years, the depth of focus at which a projected image is formed decreases as miniaturization advances, so the unevenness on the substrate surface to be coated with a curable composition must be decreased to 4 nm or less. Flatness equivalent to that of EUV is required in a nanoimprint lithography (NIL) technique as another photolithography technique as well, in order to improve the filling properties and the line width accuracy (NPL 1). As the planarization technique, a technique is known in which droplets of a liquid curable composition are discretely dropped on a substrate having concave and convex portions by an amount corresponding to the concave and convex portions, and a flat surface is obtained by curing the curable composition in a state in which a mold having a flat surface is pressed against the curable composition (PTLs 1 and 2).

In the abovementioned pattern formation techniques and planarization technique, a high throughput is required to improve the productivity, and spread and filling are steps requiring the longest time. It is known that in the photonanoimprint technique, the filling rate improves by using helium and air as an ambient gas (NPL 2).

CITATION LIST

PATENT LITERATURE

PTL 1: Japanese Patent Laid-Open No. 2019-140394
PTL2: US-2020-0286740
PTL 3: Japanese Patent Laid-Open No. 2009-503139

NON PATENT LITERATURE

NPL 1: N. Shiraishi/Int. J. Microgravity Sci. No. 31 Supplement 2014 (S5-S12)
NPL 2: Proc. SPIE 11324-11 (2020)
NPL 3: Susumu Okazaki, "Basis of Computer Simulation", KAGAKUDOJIN (2000)
NPL 4: B. H. Besler, K. M. Merz Jr., and P. A. Kollman, J. Comp. Chem. 11, 431 (1990).
NPL 5: U. C. Singh and P. A. Kollman, J. Comp. Chem. 5, 129 (1984).
NPL 6: Wang, J., Wolf, R. M., Caldwell, J. W., Kollman, P. A., Case, D. A., J. Comp. Chem. 25, 1157 (2004).

## SUMMARY OF INVENTION

The present inventors found a problem that the thicker the liquid film thickness of a curable composition is, the longer the time required for spread and filling is.

The present invention provides a technique advantageous in suppressing lowering of a filling rate even in a case where the liquid film thickness of a curable composition is thick.

According to one aspect of the present invention, there is provided a film forming method comprising an arranging step of arranging a curable composition on a base material, a contact step of bringing the curable composition into contact with a film forming region of a mold after the arranging step, a curing step of curing the curable composition after the contact step, and a separation step of separating the curable composition and the mold after the curing step, wherein in the contact step, a gas that fills a space between the base material and the mold exists, a solubility coefficient of the gas to the curable composition is not less than 0.5 $kg/m^3 \cdot atm$ and not more than 10 $kg/m^3 \cdot atm$, and an average liquid film thickness that is a value obtained by dividing a volume of the curable composition by an area of the film forming region is not less than 70 nm.

Other features and advantages of the present invention will be apparent from the following description taken in conjunction with the accompanying drawings. Note that the same reference numerals denote the same or like components throughout the accompanying drawings.

## BRIEF DESCRIPTION OF DRAWINGS

The accompanying drawings, which are incorporated in and constitute a part of the specification, illustrate embodiments of the invention and, together with the description, serve to explain principles of the invention.

Fig. 1 is a schematic sectional view showing a film forming method according to the embodiment;

Fig. 2 is a schematic sectional view showing the definition of an average liquid film thickness;

Fig. 3 is an explanatory view of an approximation operation performed when calculating an air bubble disappearance time;

Fig. 4A is a view for explaining an article manufacturing method;

Fig. 4B is a view for explaining the article manufacturing method;

Fig. 4C is a view for explaining the article manufacturing method;

Fig. 4D is a view for explaining the article manufacturing method;

Fig. 4E is a view for explaining the article manufacturing method;

Fig. 4F is a view for explaining the article manufacturing method;

Fig. 5A is a view for explaining an article manufacturing method;

Fig. 5B is a view for explaining the article manufacturing method;

Fig. 5C is a view for explaining the article manufacturing method; and

Fig. 5D is a view for explaining the article manufacturing method.

## DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

[Curable Composition]

A curable composition (A) according to this embodiment is a composition containing at least a component (a) as a polymerizable compound. The curable composition according to this embodiment can further contain a component (b) as a photopolymerization initiator, a nonpolymerizable compound (c), and a component (d) as a solvent.
In this specification, a cured film means a film cured by polymerizing a curable composition on a substrate. Note that the shape of the cured film is not particularly limited, so the film can have a pattern shape on the surface.

<Component (a): Polymerizable Compound>

The component (a) is a polymerizable compound. In this specification, the polymerizable compound is a compound that reacts with a polymerizing factor (for example, a radical) generated from a photopolymerization initiator (the component (b)), and forms a film made of a polymer compound by a chain reaction (polymerization reaction).
An example of the polymerizable compound as described above is a radical polymerizable compound. The polymerizable compound as the component (a) can be formed by only one type of a polymerizable compound, and can also be formed by a plurality of types of polymerizable compounds.
Examples of the radical polymerizable compound are (meth)acrylic compounds, styrene compounds, vinyl compounds, allylic compounds, fumaric compounds, and maleic compounds. The radical polymerizable compound is preferably a compound having one or more acryloyl groups or methacryloyl groups, that is, a (meth)acrylic compound. Accordingly, the curable composition according to this embodiment preferably contains a (meth)acrylic compound as the component (a). More preferably, a main component of the component (a) is a (meth)acrylic compound, and most preferably, the curable composition is a (meth)acrylic compound. Note that "a main component of the component (a) is a (meth)acrylic compound" described herein means that 90 mass% or more of the component (a) is a (meth)acrylic compound.
When the radical polymerizable compound is formed by a plurality of types of compounds having one or more acryloyl groups or methacryloyl groups, the radical polymerizable compound preferably contains a monofunctional (meth) acrylic monomer and a polyfunctional (meth)acrylic monomer. This is so because a cured film having a high mechanical strength can be obtained by combining the monofunctional (meth)acrylic monomer and the polyfunctional (meth)acrylic monomer.
Examples of the monofunctional (meth)acrylic compound having one acryloyl group or methacryloyl group are as follows, but the compound is not limited to these examples. Phenoxyethyl (meth)acrylate, phenoxy-2-methylethyl (meth) acrylate, phenoxyethoxyethyl (meth)acrylate, 3-phenoxy-2-hydroxypropyl (meth)acrylate, 2-phenylphenoxyethyl (meth) acrylate, 4-phenylphenoxyethyl (meth)acrylate, 3-(2-phenylphenyl)-2-hydroxypropyl (meth)acrylate, (meth)acrylate of EO-modified p-cumylphenol, 2-bromophenoxyethyl (meth)acrylate, 2,4-dibromophenoxyethyl (meth)acrylate, 2,4,6-tribromophenoxyethyl (meth)acrylate, EO-modified phenoxy (meth)acrylate, PO-modified phenoxy (meth)acrylate, polyoxyethylenenonylphenylether (meth)acrylate, isobornyl (meth)acrylate, 1-adamantyl (meth)acrylate, 2-methyl-2-adamantyl (meth)acrylate, 2-ethyl-2-adamantyl (meth)acrylate, bornyl (meth)acrylate, tricyclodecanyl (meth)acrylate, dicyclopentanyl (meth)acrylate, dicyclopentenyl (meth)acrylate, cyclohexyl (meth)acrylate, 4-butylcyclohexyl (meth)acrylate, acryloylmorpholine, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, undecyl (meth)acrylate, dodecyl (meth)acrylate, lauryl (meth)acrylate, stearyl (meth)acrylate, isostearyl (meth)acrylate, benzyl (meth)acrylate, tetrahydrofurfuryl (meth)acrylate, butoxyethyl (meth)acrylate, ethoxydiethyleneglycol (meth)acrylate, polyethyleneglycol mono(meth)acrylate, polypropyleneglycol mono(meth)acrylate, methoxyethyleneglycol (meth)acrylate, ethoxyethyl (meth)acrylate, methoxypolyethyleneglycol (meth)acrylate, methoxypolypropyleneglycol (meth)acrylate, diacetone (meth)acrylamide, isobutoxymethyl (meth)acrylamide, N,N-dimethyl (meth)acrylamide, t-octyl (meth)acrylamide, dimethylaminoethyl (meth)acrylate, diethylaminoethyl (meth)acrylate, 7-amino-3,7-dimethyloctyl (meth)acrylate, N,N-diethyl (meth)acrylamide, and N,N-dimethylaminopropyl (meth)acrylamide.
Examples of commercially available products of the abovementioned monofunctional (meth)acrylic compounds are as follows, but the products are not limited to these examples. ARONIX® M101, M102, M110, M111, M113, M117, M5700, TO-1317, M120, M150, and M156 (manufactured by TOAGOSEI); MEDOL10, MIBDOL10, CHDOL10, MMDOL30, MEDOL30, MIBDOL30, CHDOL30, LA, IBXA, 2-MTA, HPA, and Viscoat #150, #155, #158, #190, #192, #193, #220, #2000, #2100, and #2150 (manufactured by OSAKA ORGANIC CHEMICAL INDUSTRY); Light Acrylate BO-A, EC-A, DMP-A, THF-A, HOP-A, HOA-MPE, HOA-MPL, PO-A, P-200A, NP-4EA, NP-8EA, and Epoxy Ester M-600A (manufactured by KYOEISHA CHEMICAL); KAYARAD® TC110S, R-564, and R-128H (manufactured by NIPPON KAYAKU); NK Ester AMP-10G, AMP-20G, andA-LEN-10 (manufactured by SHIN-NAKAMURA CHEMICAL);

FA-511A, 512A, and 513A (manufactured by Hitachi Chemical); PHE, CEA, PHE-2, PHE-4, BR-31, BR-31M, and BR-32 (manufactured by DKS); VP (manufactured by BASF); and ACMO, DMAA, and DMAPAA (manufactured by Kohjin).

Examples of a polyfunctional (meth)acrylic compound having two or more acryloyl groups or methacryloyl groups are as follows, but the compound is not limited to these examples. Trimethylolpropane di(meth)acrylate, trimethylolpropane tri(meth)acrylate, EO-modified trimethylolpropane tri(meth)acrylate, PO-modified trimethylolpropane tri(meth)acrylate, EO- and PO-modified trimethylolpropane tri(meth)acrylate, dimethylol tricyclodecane di(meth)acrylate, pentaerythritol tri(meth)acrylate, pentaerythritol tetra(meth)acrylate, ethylene glycol di(meth)acrylate, tetraethylene glycol di(meth)acrylate, polyethylene glycol di(meth)acrylate, polypropylene glycol di(meth)acrylate, 1,4-butanediol di(meth) acrylate, 1,6-hexanediol di(meth)acrylate, neopentyl glycol di(meth)acrylate, 1,9-nonanediol di(meth)acrylate, 1,10-decanediol di(meth)acrylate, 1,3-adamantanedimethanol di(meth)acrylate, tris(2-hydoxyethyl)isocyanurate tri(meth)acrylate, tris(acryloyloxy)isocyanurate, bis(hydroxymethyl)tricyclodecane di(meth)acrylate, dipentaerythritol penta(meth) acrylate, dipentaerythritol hexa(meth)acrylate, EO-modified 2,2-bis(4-((meth)acryloxy)phenyl)propane, PO-modified 2,2-bis(4-((meth)acryloxy)phenyl)propane, EO- and PO-modified 2,2-bis(4-((meth)acryloxy)phenyl)propane.

Examples of commercially available products of the abovementioned polyfunctional (meth)acrylic compounds are as follows, but the products are not limited to these examples. Yupimer® UV SA1002 and SA2007 (manufactured by Mitsubishi Chemical); Viscoat #195, #230, #215, #260, #335HP, #295, #300, #360, #700, GPT, and 3PA (manufactured by OSAKA ORGANIC CHEMICAL INDUSTRY); Light Acrylate 4EG-A, 9EG-A, NP-A, DCP-A, BP-4EA, BP-4PA, TMP-A, PE-3A, PE-4A, and DPE-6A (manufactured by KYOEISHA CHEMICAL); KAYARAD® PET-30, TMPTA, R-604, DPHA, DPCA-20, -30, - 60, and -120, HX-620, D-310, and D-330 (manufactured by NIPPON KAYAKU); ARONIX® M208, M210, M215, M220, M240, M305, M309, M310, M315, M325, and M400 (manufactured by TOAGOSEI); and Ripoxy® VR-77, VR-60, and VR-90 (manufactured by Showa Highpolymer).

Note that in the above-described compounds, (meth)acrylate means acrylate or methacrylate having an alcohol residue equal to acrylate. A (meth)acryloyl group means an acryloyl group or a methacryloyl group having an alcohol residue equal to the acryloyl group. EO indicates ethylene oxide, and an EO-modified compound A indicates a compound in which a (meth)acrylic acid residue and an alcohol residue of a compound A bond via the block structure of an ethylene oxide group. Also, PO indicates a propylene oxide, and a PO-modified compound B indicates a compound in which a (meth)acrylic acid residue and an alcohol residue of a compound B bond via the block structure of a propylene oxide group.

Practical examples of the styrene-based compound are as follows, but the compound is not limited to these examples.

Alkylstyrene such as styrene, 2,4-dimethyl-α-methylstyrene, o-methylstyrene, m-methylstyrene, p-methylstyrene, 2,4-dimethylstyrene, 2,5-dimethylstyrene, 2,6-dimethylstyrene, 3,4-dimethylstyrene, 3,5-dimethylstyrene, 2,4,6-trimethylstyrene, 2,4,5-trimethylstyrene, pentamethylstyrene, o-ethylstyrene, m-ethylstyrene, p-ethylstyrene, diethylstyrene, triethylstyrene, propylstyrene 2,4-diisopropyl styrene, butylstyrene, hexylstyrene, heptylstyrene, and octylstyrene; styrene halide such as fluorostyrene, o-chlorostyrene, m-chlorostyrene, p-chlorostyrene, o-bromostyrene, m-bromostyrene, p-bromostyrene, dibromostyrene, and iodostyrene; and a compound having a styryl group as a polymerizable functional group, such as nitrostyrene, acetyl styrene, o-methoxystyrene, m-methoxystyrene, p-methoxystyrene, o-hydroxystyrene, m-hydroxystyrene, p-hydroxystyrene, 2-vinylbiphenyl, 3-vinylbiphenyl, 4-vinylbiphenyl, 1-vinylnaphthalene, 2-vinylnaphthalene, 4-vinyl-p-terphenyl, 1-vinylanthracene, α-methylstyrene, o-isopropenyltoluene, m-isopropenyltoluene, p-isopropenyltoluene, 2,3-dimethyl-α-methyl styrene, 3,5-dimethyl-α-methylstyrene, p-isopropyl-α-methylstyrene, α-ethylstyrene, α-chlorostyrene, divinylbenzene, diisopropylbenzene, and divinylbiphenyl.

Practical examples of the vinyl-based compound are as follows, but the compound is not limited to these examples.

Vinylpyridine, vinylpyrrolidone, vinylcarbazole, vinyl acetate, and acrylonitrile; conjugated diene monomers such as butadiene, isoprene, and chloroprene; vinyl halide such as vinyl chloride and vinyl bromide; a compound having a vinyl group as a polymerizable functional group, for example, vinylidene halide such as vinylidene chloride, vinyl ester of organic carboxylic acid and its derivative (for example, vinyl acetate, vinyl propionate, vinyl butyrate, vinyl benzoate, and divinyl adipate), and (meth)acrylonitrile.

Note that in this specification, (meth)acrylonitrile is a general term for acrylonitrile and methacrylonitrile.

Examples of the allylic compound are as follows, but the compound is not limited to these examples.

Allyl acetate, allyl benzoate, diallyl adipate, diallyl terephthalate, diallyl isophthalate, and diallyl phthalate.

Examples of the fumaric compound are as follows, but the compound is not limited to these examples.

Dimethyl fumarate, diethyl fumarate, diisopropyl fumarate, di-sec-butyl fumarate, diisobutyl fumarate, di-n-butyl fumarate, di-2-ethylhexyl fumarate, and dibenzyl fumarate.

Examples of the maleic compound are as follows, but the compound is not limited to these examples.

Dimethyl maleate, diethyl maleate, diisopropyl maleate, di-sec-butyl maleate, diisobutyl maleate, di-n-butyl maleate, di-2-ethylhexyl maleate, and dibenzyl maleate.

Other examples of the radical polymerizable compound are as follows, but the compound is not limited to these examples.

Dialkylester of itaconic acid and its derivative (for example, dimethyl itaconate, diethyl itaconate, diisopropyl itaconate, di-sec-butyl itaconate, diisobutyl itaconate, di-n-butyl itaconate, di-2-ethylhexyl itaconate, and dibenzyl itaconate), an N-vinylamide derivative of organic carboxylic acid (for example, N-methyl-N-vinylacetamide), and maleimide and its derivative (for example, N-phenylmaleimide and N-cyclohexylmaleimide).

If the component (a) is formed by a plurality of types of compounds having one or more polymerizable functional groups, a monofunctional compound and a polyfunctional compound are preferably included. This is because if a monofunctional compound and a polyfunctional compound are combined, a cured film having well-balanced performance, for example, a high mechanical strength, a high dry etching resistance, and a high heat resistance can be obtained.

Since the polymerizable compound (a) preferably has low volatility, it may contain a plurality of types of compounds. The boiling points of all the compounds at normal pressure are preferably 250°C or more, more preferably 300°C or more, and further preferably 350°C or more. The boiling point of the polymerizable compound (a) is almost correlated with the molecular weight. Therefore, the molecular weights of all the polymerizable compounds (a) are preferably 200 or more, more preferably 240 or more, and further preferably 250 or more. However, even when the molecular weight is 200 or less, the compound is preferably usable as the polymerizable compound (a) of the present invention if the boiling point is 250°C or more.

In addition, the vapor pressure at 80°C of the polymerizable compound (a) is preferably 0.001 mmHg or less. This is so because, although it is favorable to heat the curable composition when accelerating volatilization of the solvent (d) (to be described later), it is necessary to suppress volatilization of the polymerizable compound (a) during heating.

Note that the boiling point and the vapor pressure of each organic compound at normal pressure can be calculated by, for example, Hansen Solubility Parameters in Practice (HSPiP) 5th Edition. 5.3.04.

Practical examples of the polymerizable compound (a) having a boiling point of 250°C or more are as follows, but the compound is not limited to these examples.

dicyclopentanyl acrylate (boiling point = 262°C, molecular weight = 206) dicyclopentenyl acrylate (boiling point = 270°C, molecular weight = 204)
1,3-cyclohexanedimethanol diacrylate (boiling point = 310°C, molecular weight = 252)
1,4-cyclohexanedimethanol diacrylate (boiling point = 339°C, molecular weight = 252)
4-hexylresolsinol diacrylate (boiling point = 379°C, molecular weight = 302)
6-phenylhexane-1,2-diol diacrylate (boiling point = 381°C, molecular weight = 302)
7-phenylheptan-1,2-diol diacrylate (boiling point = 393°C, molecular weight = 316)
1,3-bis((2-hydroxyethoxy)methyl)cyclohexane diacrylate (boiling point = 403°C, molecular weight = 340)
8-phenyloctane-1,2-diol diacrylate (boiling point = 404°C, molecular weight = 330)
1,3-bis((2-hydroxyethoxy)methyl)benzene diacrylate (boiling point = 408°C, molecular weight = 334)
1,4-bis((2-hydroxyethoxy)methyl)cyclohexane diacrylate (boiling point = 445°C, molecular weight = 340)
3-phenoxybenzyl acrylate (mPhOBzA, OP = 2.54, boiling point = 367.4°C, 80°C vapor pressure = 0.0004 mmHg, molecular weight = 254.3)

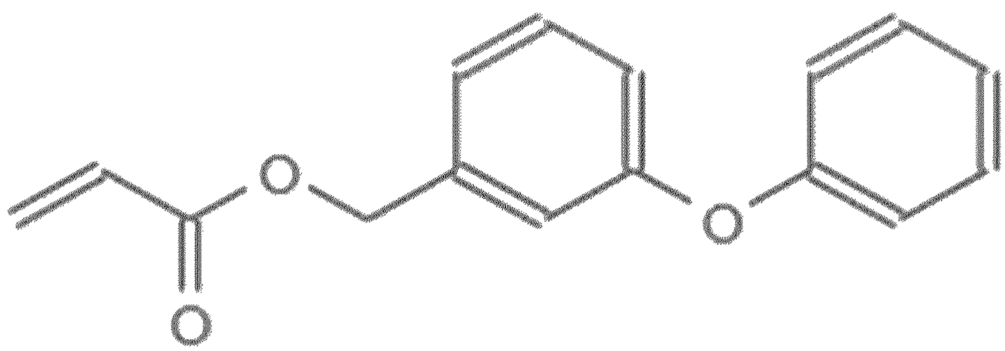

1-naphthyl acrylate (NaA, OP = 2.27, boiling point = 317°C, 80°C vapor pressure = 0.0422 mmHg, molecular weight = 198)

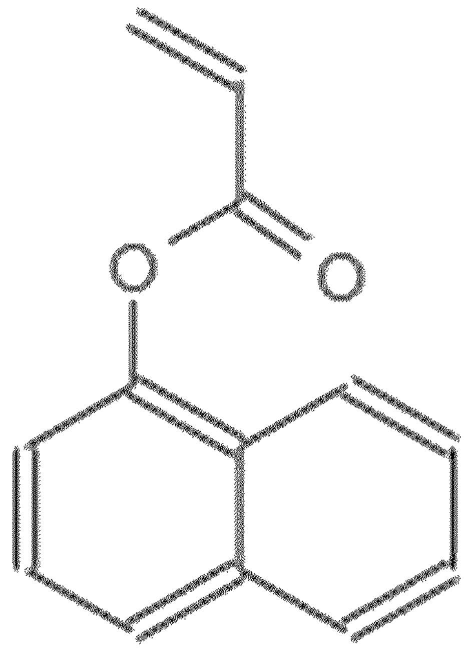

2-phenylphenoxyethyl acrylate (PhPhOEA, OP = 2.57, boiling point = 364.2°C, 80°C vapor pressure = 0.0006 mmHg, molecular weight = 268.3)

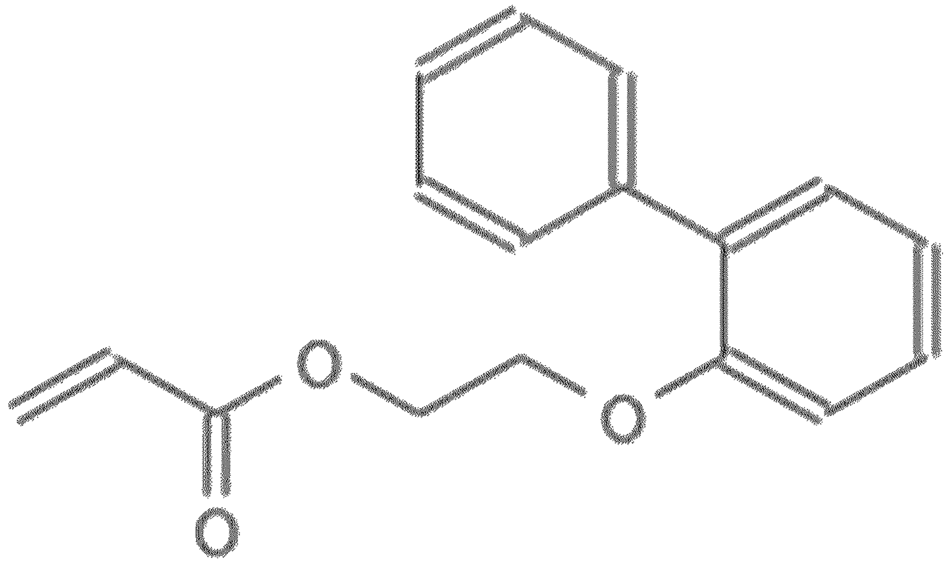

1-naphthylmethyl acrylate (Na1MA, OP = 2.33, boiling point = 342.1°C, 80°C vapor pressure = 0.042 mmHg, molecular weight = 212.2)

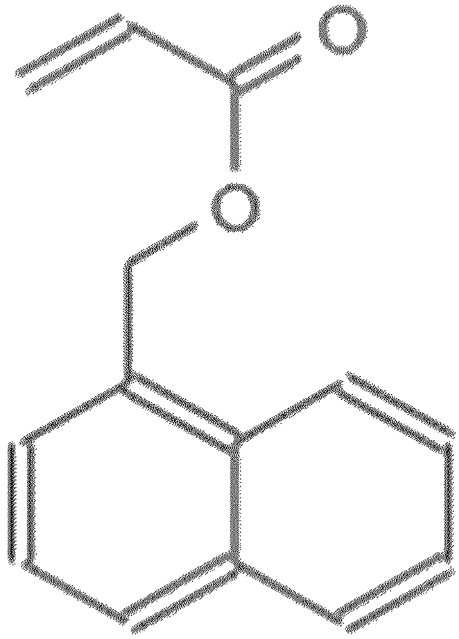

2-naphthylmethyl acrylate (Na2MA, OP = 2.33, boiling point = 342.1°C, 80°C vapor pressure = 0.042 mmHg, molecular weight = 212.2)

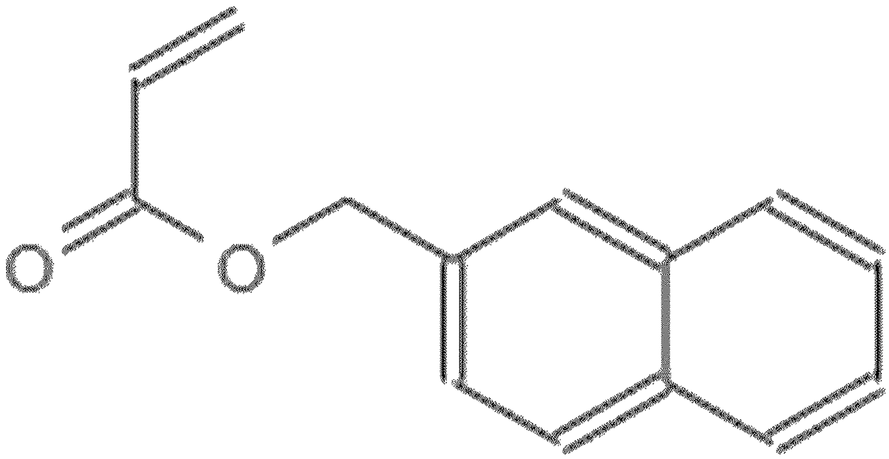

4-cyanobenzyl acrylate (CNBzA, OP = 2.44, boiling point = 316°C, molecular weight = 187)

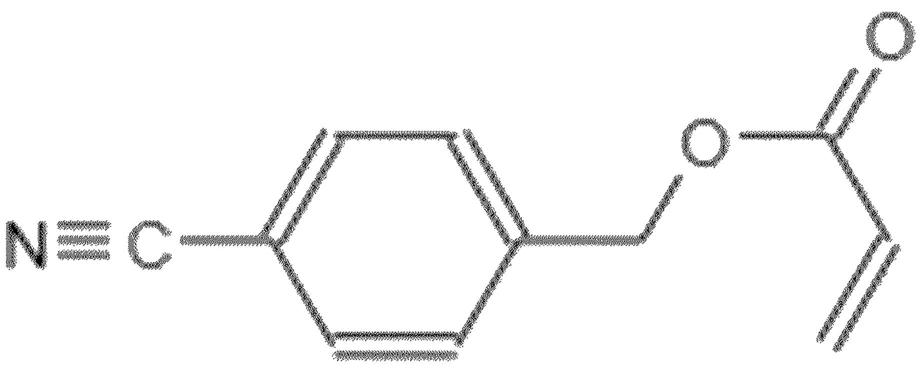

DVBzA indicated by the formula below (OP = 2.50, boiling point = 304.6°C, 80°C vapor pressure = 0.0848 mmHg, molecular weight = 214.3)

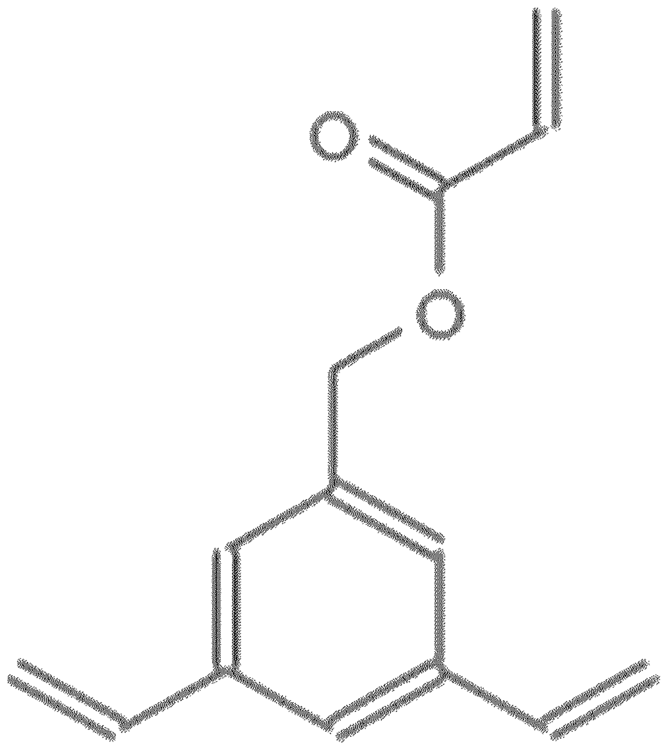

DPhPA indicated by the formula below (OP = 2.38, boiling point = 354.5°C, 80°C vapor pressure = 0.0022 mmHg, molecular weight = 266.3)

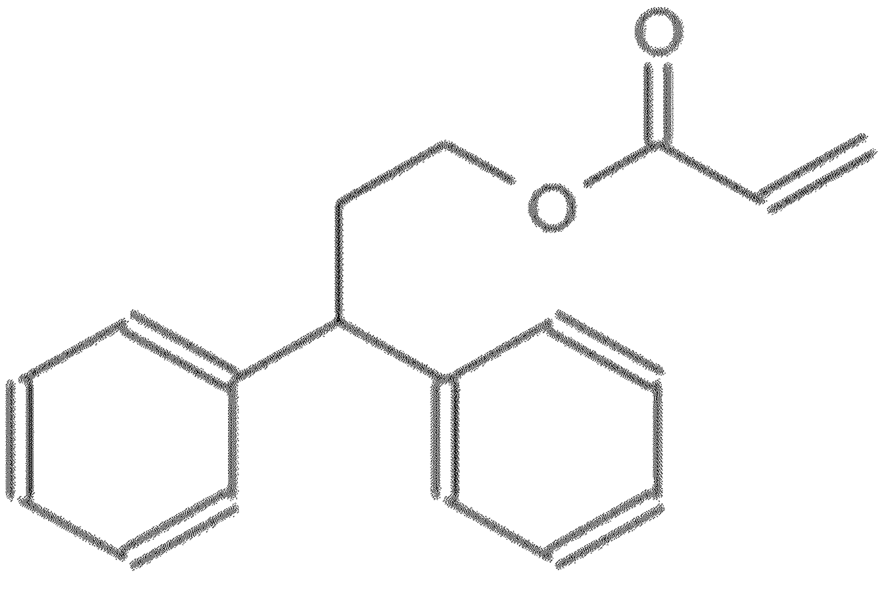

PhBzA indicated by the formula below (OP = 2.29, boiling point = 350.4°C, 80°C vapor pressure = 0.0022 mmHg, molecular weight = 238.3)

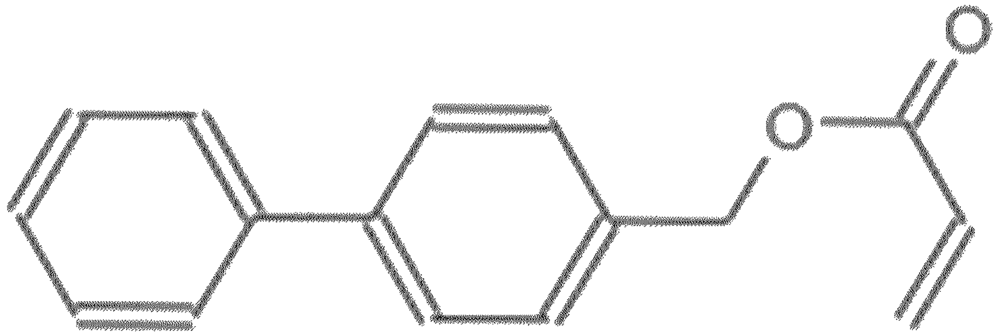

FLMA indicated by the formula below (OP = 2.20, boiling point = 349.3°C, 80°C vapor pressure = 0.0018 mmHg, molecular weight = 250.3)

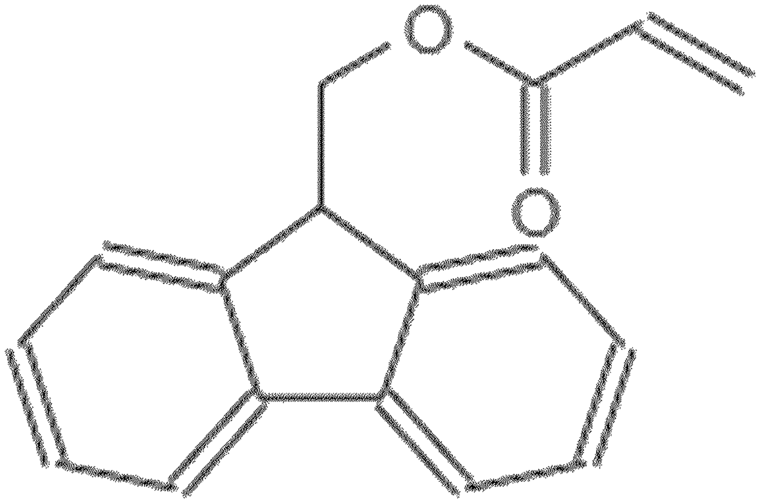

ATMA indicated by the formula below (OP = 2.13, boiling point = 414.9°C, 80°C vapor pressure = 0.0001 mmHg, molecular weight = 262.3)

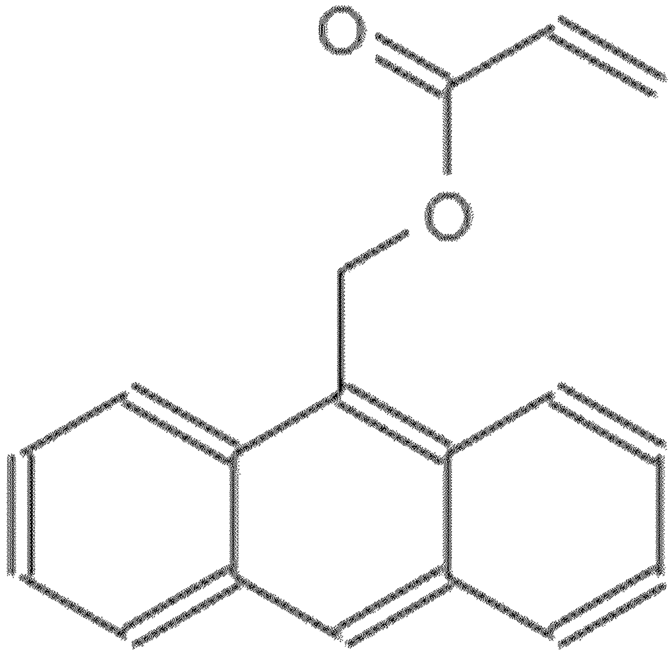

DNaMA indicated by the formula below (OP = 2.00, boiling point = 489.4°C, 80°C vapor pressure < 0.0001 mmHg,

molecular weight = 338.4)

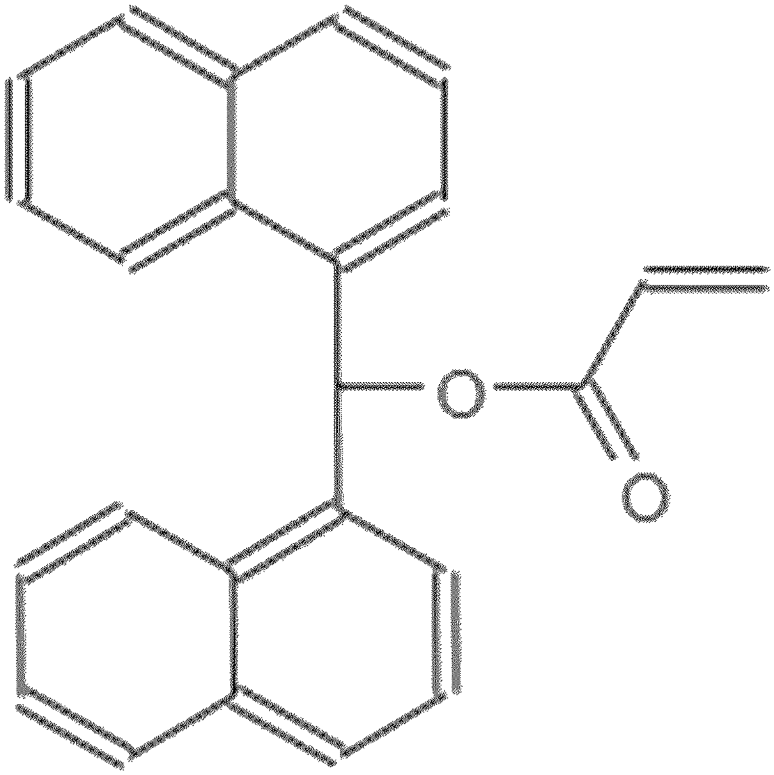

tricyclodecanedimethanol diacrylate (DCPDA, OP = 3.29, boiling point = 342°C, 80°C vapor pressure < 0.0024 mmHg, molecular weight = 304)

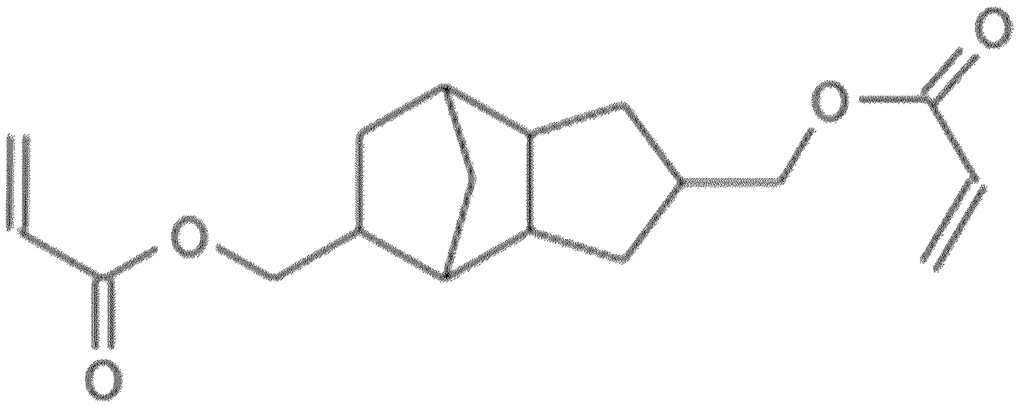

m-xylylene diacrylate (mXDA, OP = 3.20, boiling point = 336°C, 80°C vapor pressure < 0.0043 mmHg, molecular weight = 246)

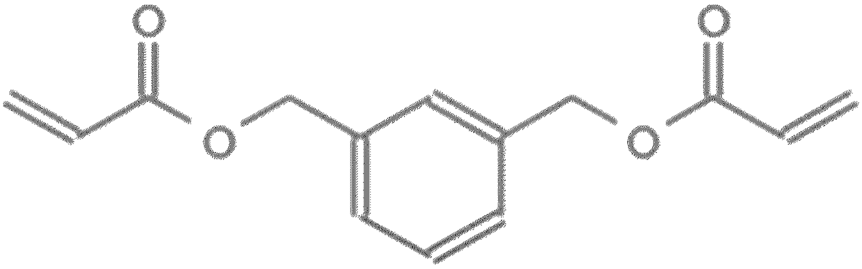

1-phenylethane-1,2-diyl diacrylate (PhEDA, OP = 3.20, 80°C vapor pressure < 0.0057 mmHg, boiling point = 354°C, molecular weight = 246)

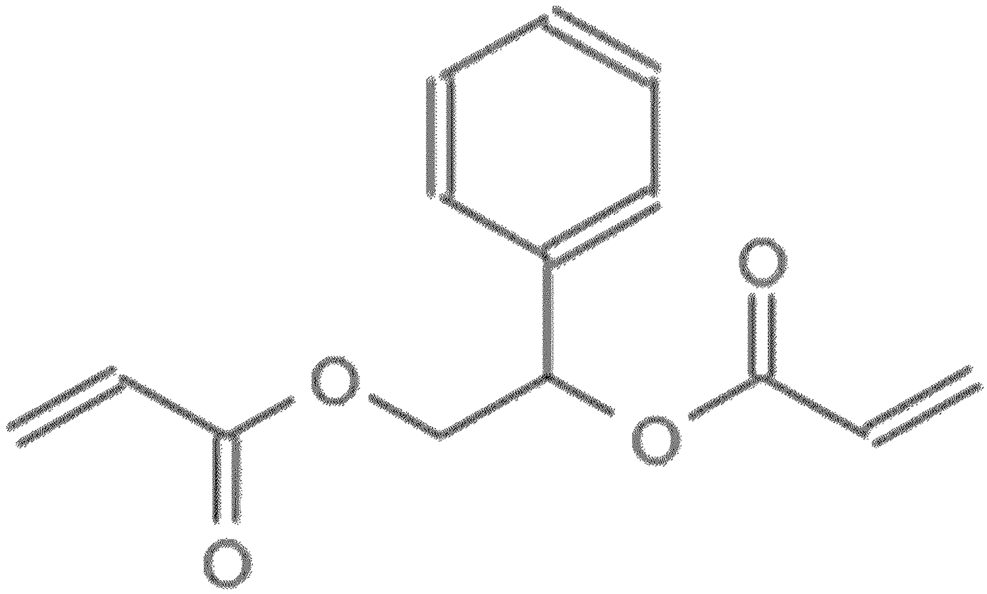

2-phenyl-1,3-propan diol diacrylate (PhPDA, OP = 3.18, boiling point = 340°C, 80°C vapor pressure < 0.0017 mmHg, molecular weight = 260)

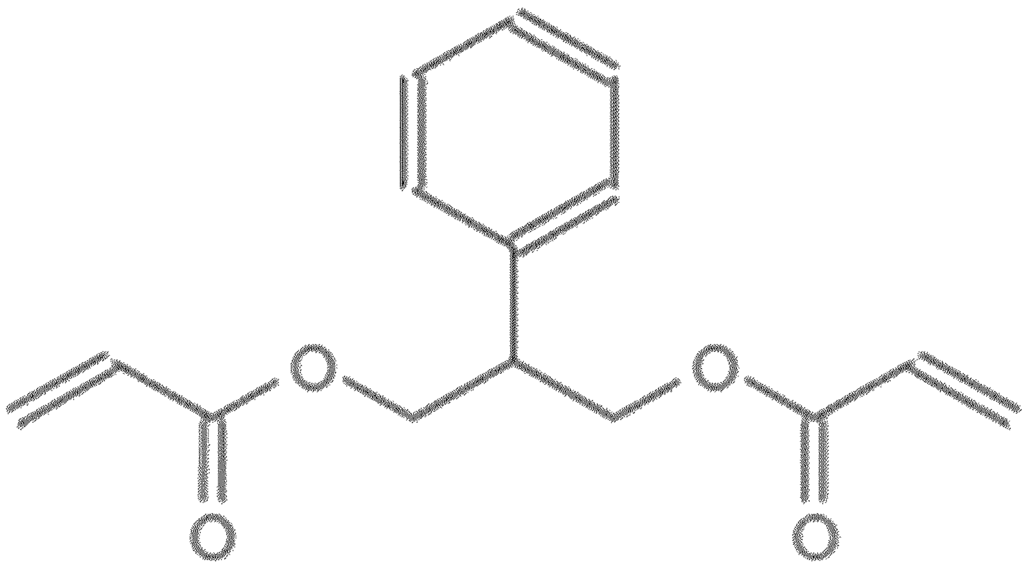

VmXDA indicated by the formula below (OP = 3.00, boiling point = 372.4°C, 80°C vapor pressure = 0.0005 mmHg, molecular weight = 272.3)

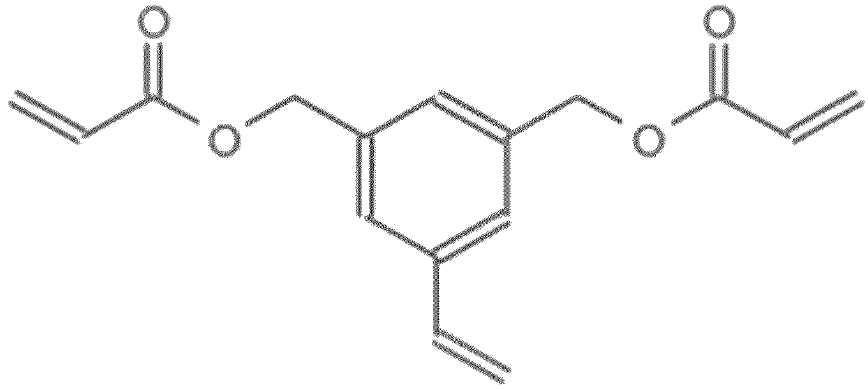

BPh44DA indicated by the formula below (OP = 2.63, boiling point = 444°C, 80°C vapor pressure < 0.0001 mmHg, molecular weight = 322.3)

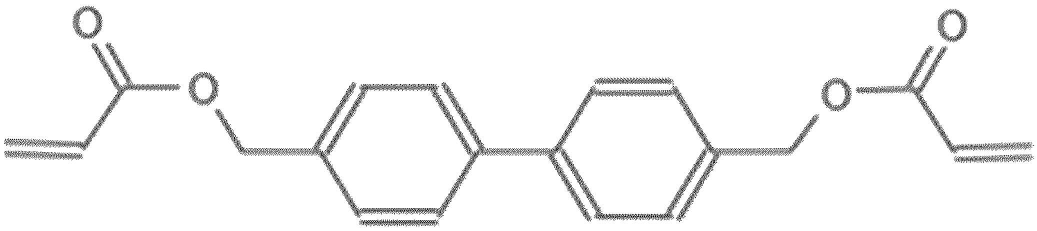

BPh43DA indicated by the formula below (OP = 2.63, boiling point = 439.5°C, 80°C vapor pressure < 0.0001 mmHg, molecular weight = 322.3)

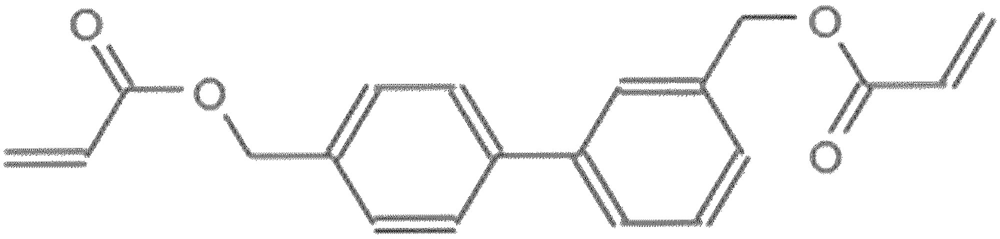

DPhEDA indicated by the formula below (OP = 2.63, boiling point = 410°C, 80°C vapor pressure < 0.0001 mmHg, molecular weight = 322.3)

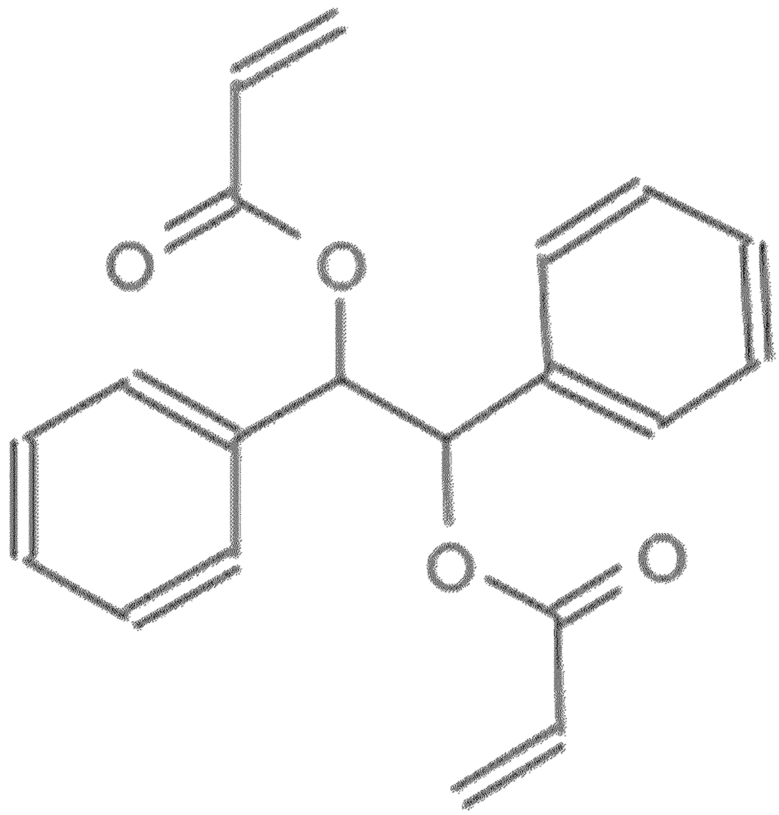

BPMDA indicated by the formula below (OP = 2.68, boiling point = 465.7°C, 80°C vapor pressure < 0.0001 mmHg, molecular weight = 364.4)

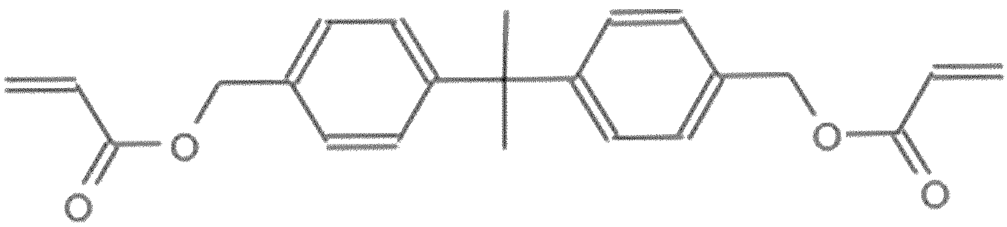

Na13MDA indicated by the formula below (OP = 2.71, boiling point = 438.8°C, 80°C vapor pressure < 0.0001 mmHg, molecular weight = 296.3)

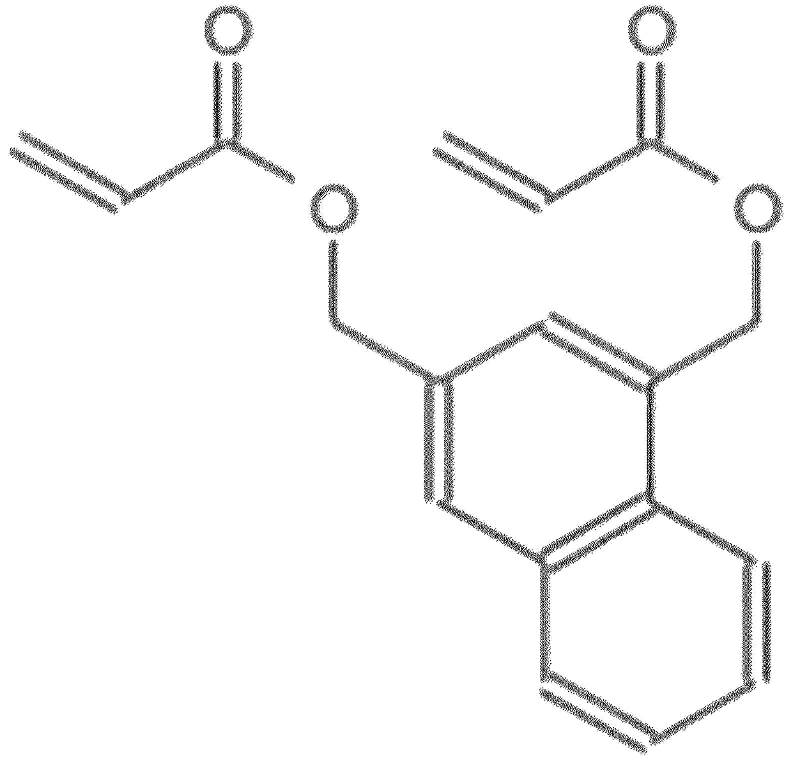

The blending ratio of the component (a) in the curable composition (A) is preferably 40 wt% or more and 99 wt% or less with respect to the sum of the component (a), a component (b) (to be described later), and a component (c) (to be described later), that is, the total mass of all the components except the solvent (d). The blending ratio is more preferably 50 wt% or more and 95 wt% or less, and further preferably 60 wt% or more and 90 wt% or less. When the blending ratio of the component (a) is 40 wt% or more, the mechanical strength of the cured film of the curable composition increases. Also, when the blending ratio of the component (a) is 99 wt% or less, it is possible to increase the blending ratios of the components (b) and (c), and obtain characteristics such as a high photopolymerization rate.

<Component (b): Photopolymerization Initiator>

The component (b) is a photopolymerization initiator. In this specification, the photopolymerization initiator is a compound that senses light having a predetermined wavelength and generates the polymerization factor (radical) described earlier. More specifically, the photopolymerization initiator is a polymerization initiator (radical generator) that generates a radical by light (infrared light, visible light, ultraviolet light, far-ultraviolet light, X-ray, a charged particle beam such as an electron beam, or radiation). The component (b) can be formed by only one type of a photopolymerization initiator, and can also be formed by a plurality of types of photopolymerization initiators.

Examples of the radical generator are as follows, but the radical generator is not limited to these examples. 2,4,5-triarylimidazole dimers that can have substituent groups, such as a 2-(o-chlorophenyl)-4,5-diphenylimidazole dimer, a 2-(o-chlorophenyl)-4,5-di(methoxyphenyl)imidazole dimer, a 2-(o-fluorophenyl)-4,5-diphenylimidazole dimer, and a 2-(o- or p-methoxyphenyl)-4,5-diphenylimidazole dimer; benzophenone derivatives such as benzophenone, N,N'-tetramethyl-4,4'-diaminobenzophenone (Michiler's ketone), N,N'-tetraethyl-4,4'-diaminobenzophenone, 4-methoxy-4'-dimethylaminobenzophenone, 4-chlorobenzophenone, 4,4'-dimethoxybenzophenone, and 4,4'-diaminobenzophenone; $\alpha$-amino aromatic ketone derivatives such as 2-benzyl-2-dimethylamino-1 -(4-morpholinophenyl)-butanone-1,2-methyl-1 -[4-(methylthio)phenyl]-2-morpholino-propane-1-one; quinones such as 2-ethylanthraquinone, phenanthrenequinone, 2-t-butylanthraquinone, octamethylanthraquinone, 1,2-benzanthraquinone, 2,3-benzanthraquinone, 2-phenylanthraquinone, 2,3-diphenylamthraquinone, 1-chloroanthraquinone, 2-methylanthraquinone, 1,4-naphtoquinone, 9,10-phenanthraquinone, 2-methyl-1,4-naphtoquinone, and 2,3-dimethylanthraquinone; benzoin ether derivatives such as benzoin methyl ether, benzoin ethyl ether, and benzoin phenyl ether; benzoin derivatives such as benzoin, methyl benzoin, ethyl benzoin, and propyl benzoin; benzyl derivatives such as benzyldimethylketal; acridine derivatives such as 9-phenyl acridine and 1,7-bis(9,9'-acrydinyl)heptane; N-phenylglycine derivatives such as N-phenylglycine; acetophenone derivatives such as acetophenone, 3-methylacetophenone, acetophenone benzylketal, 1-hydroxycylohexyl phenylketone, and 2,2-dimethoxy-2-phenyl acetophenone; thioxanthone derivatives such as thioxanthone, diethylthioxanthone, 2-isopropylthioxanthone, and 2-chlorothioxanthone; acylphosphine oxide derivatives such as 2,4,6-trimethylbenzoyldiphenylphosphine oxide, bis(2,4,6-trimethylbenzoyl)phenylphosphine oxide, and bis-(2,6-dimethoxybenzoyl)-2,4,4-trimethylpentylphosphine oxide; oxime ester derivatives such as 1,2-octanedione, 1-[4-(phenylthiol)-,2-(O-benzoyloxime)], ethanone, 1-[9-ethyl-6-(2-methylbenzoyl)-9H-carbazole-3-yl]-, and 1-(O-acetyloxime); and xanthone, fluorenone, benzaldehyde, fluorene, anthraquinone, triphenylamine, carbazole, 1-(4-isopropylphenyl)-2-hydroxy-2-methylprapane-1-one, and 2-hydroxy-2-methyl-1 -phenylpropane-1 -one.

Examples of commercially available products of the above-described radical generators are as follows, but the products are not limited to these examples. Irgacure 184, 369, 651, 500, 819, 907, 784, and 2959, CGI-1700, - 1750, and -1850, CG24-61, Darocur 1116 and 1173, Lucirin® TPO, LR8893, and LR8970 (manufactured by BASF), and Ubecryl P36 (manufactured by UCB).

Of the above-described radical generators, the component (b) is preferably an acylphosphine oxide-based polymerization initiator. Note that in the abovementioned examples, the acylphosphine oxide-based polymerization initiators are acylphosphine oxide compounds such as 2,4,6-trimethylbenzoyl diphenylphosphine oxide, bis(2,4,6-trimethylbenzoyl)phenylphosphine oxide, and bis(2,6-dimethoxybenzoyl)-2,4,4-trimethylpentylphosphine oxide.

The blending ratio of the component (b) in the curable composition (A) is preferably 0.1 mass% or more and 50 mass% or less, more preferably 0.1 mass% or more and 20 mass% or less, and further preferably 1 mass% or more and 20 mass% or less, with respect to the total of the component (a), the component (b), and the component (c) (to be described later), that is, the total mass of all the components except the solvent component (d). When the blending ratio of the component (b) is 0.1 mass% or more, the curing rate of the composition increases, so the reaction efficiency can be increased. When the blending ratio is 50 mass% or less, a cured film having a mechanical strength to some extent can be obtained.

<Component (c): Nonpolymerizable Compound>

In addition to the components (a) and (b) described above, the curable composition (A) according to this embodiment can further contain a nonpolymerizable compound as the component (c) within a range that does not impair the effect of this embodiment, in accordance with various purposes. An example of the component (c) is a compound that does not contain a polymerizable functional group such as a (meth)acryloyl group, and does not have the ability to sense light having a predetermined wavelength and to generate the polymerization factor (radical) described previously. Examples of the nonpolymerizable compound are a sensitizer, a hydrogen donor, an internal mold release agent, an antioxidant, a polymer component, and other additives. The component (c) can contain a plurality of types of the above-described compounds.

The sensitizer is a compound that is properly added for the purpose of promoting the polymerization reaction and improving the reaction conversion rate. As the sensitizer, it is possible to use one type of a compound alone, or to use two or more types of compounds by mixing them.

An example of the sensitizer is a sensitizing dye. The sensitizing dye is a compound that is excited by absorbing light having a specific wavelength and has an interaction with a photopolymerization initiator as the component (b).

Note that the "interaction" herein described is, for example, energy transfer or electron transfer from the sensitizing dye in the excited state to the photopolymerization initiator as the component (b). Practical examples of the sensitizing dye are as follows, but the sensitizing dye is not limited to these examples. An anthracene derivative, an anthraquinone derivative, a pyrene derivative, a perylene derivative, a carbazole derivative, a benzophenone derivative, a thioxanthone derivative, a xanthone derivative, a coumarin derivative, a phenothiazine derivative, a camphorquinone derivative, an acridinic dye, a thiopyrylium salt-based dye, a merocyanine-based dye, a quinoline-based dye, a styryl quinoline-based dye, a ketocoumarin-based dye, a thioxanthene-based dye, a xanthene-based dye, an oxonol-based dye, a cyanine-based dye, a rhodamine-based dye, and a pyrylium salt-based dye.

The hydrogen donor is a compound that reacts with an initiation radical generated from the photopolymerization initiator as the component (b) or a radical at a polymerization growth end, and generates a radical having higher reactivity. The hydrogen donor is preferably added when the photopolymerization initiator as the component (b) is a photo-radical generator.

Practical examples of the hydrogen donor as described above are as follows, but the hydrogen donor is not limited to these examples. Amine compounds such as n-butylamine, di-n-butylamine, tri-n-butylphosphine, allylthiourea, s-benzylisothiuronium-p-toluenesulfinate, triethylamine, diethylaminoethyl methacrylate, triethylenetetramine, 4,4'-bis(dialkylamino)benzophenone, N,N-dimethylamino ethylester benzoate, N,N-dimethylamino isoamylester benzoate, pentyl-4-dimethylamino benzoate, triethanolamine, and N-phenylglycine; and mercapto compounds such as 2-mercapto-N-phenylbenzoimidazole and mercapto propionate ester. As the hydrogen donor, it is possible to use one type of a compound alone or to use two or more types of compounds by mixing them. The hydrogen donor can also have the function as a sensitizer.

An internal mold release agent can be added to the curable composition for the purpose of reducing the interface bonding force between a mold and the curable composition, that is, reducing the mold release force in a mold release step

(to be described later). In this specification, "internal" means that the mold release agent is added to the curable composition in advance before a curable composition arranging step. As the internal mold release agent, it is possible to use surfactants such as a silicon-based surfactant, a fluorine-based surfactant, and a hydrocarbon-based surfactant. In this embodiment, however, the addition amount of the fluorine-based surfactant is limited as will be described later. Note that the internal mold release agent according to this embodiment is not polymerizable. It is possible to use one type of an internal mold release agent alone, or to use two or more types of internal mold release agents by mixing them.

The fluorine-based surfactant includes, for example, a polyalkylene oxide (for example, polyethylene oxide or polypropylene oxide) adduct of alcohol having a perfluoroalkyl group, and a polyalkylene oxide (for example, polyethylene oxide or polypropylene oxide) adduct of perfluoropolyether. Note that the fluorine-based surfactant can have a hydroxyl group, an alkoxy group, an alkyl group, an amino group, or a thiol group in a portion (for example, a terminal group) of the molecular structure. An example is pentadecaethyleneglycol mono 1H, 1H,2H,2H-perfluorooctylether.

It is also possible to use a commercially available product as the fluorine-based surfactant. Examples of the commercially available product of the fluorine-based surfactant are as follows. MEGAFACE® F-444, TF-2066, TF-2067, and TF-2068, and DEO-15 (abbreviation) (manufactured by DIC); Fluorad FC-430 and FC-431 (manufactured by Sumitomo 3M); Surflon® S-382 (manufactured by AGC); EFTOP EF-122A, 122B, 122C, EF-121, EF-126, EF-127, and MF-100 (manufactured by Tochem Products); PF-636, PF-6320, PF-656, and PF-6520 (manufactured by OMNOVA Solutions); UNIDYNE® DS-401, DS-403, and DS-451 (manufactured by DAIKIN); and FUTAGENT® 250, 251, 222F, and 208G (manufactured by NEOS).

The internal mold release agent can also be a hydrocarbon-based surfactant. The hydrocarbon-based surfactant includes an alkyl alcohol polyalkylene oxide adduct obtained by adding alkylene oxide having a carbon number of 2 to 4 to alkyl alcohol having a carbon number of 1 to 50, and polyalkylene oxide.

Examples of the alkyl alcohol polyalkylene oxide adduct are as follows. A methyl alcohol ethylene oxide adduct, a decyl alcohol ethylene oxide adduct, a lauryl alcohol ethylene oxide adduct, a cetyl alcohol ethylene oxide adduct, a stearyl alcohol ethylene oxide adduct, and a stearyl alcohol ethylene oxide/propylene oxide adduct. Note that the terminal group of the alkyl alcohol polyalkylene oxide adduct is not limited to a hydroxyl group that can be manufactured by simply adding polyalkylene oxide to alkyl alcohol. This hydroxyl group can also be substituted by another substituent group, for example, a polar functional group such as a carboxyl group, an amino group, a pyridyl group, a thiol group, or a silanol group, or a hydrophobic group such as an alkyl group or an alkoxy group.

Examples of polyalkylene oxide are as follows. Polyethylene glycol, polypropylene glycol, their mono or dimethyl ether, mono or dioctyl ether, mono or dinonyl ether, and mono or didecyl ether, monoadipate, monooleate, monostearate, and monosuccinate.

A commercially available product can also be used as the alkyl alcohol polyalkylene oxide adduct. Examples of the commercially available product of the alkyl alcohol polyalkylene oxide adduct are as follows. Polyoxyethylene methyl ether (a methyl alcohol ethylene oxide adduct) (BLAUNON MP-400, MP-550, and MP-1000) manufactured by AOKI OIL INDUSTRIAL, polyoxyethylene decyl ether (a decyl alcohol ethylene oxide adduct) (FINESURF D-1303, D-1305, D-1307, and D-1310) manufactured by AOKI OIL INDUSTRIAL, polyoxyethylene lauryl ether (a lauryl alcohol ethylene oxide adduct) (BLAUNON EL-1505) manufactured by AOKI OIL INDUSTRIAL, polyoxyethylene cetyl ether (a cetyl alcohol ethylene oxide adduct) (BLAUNON CH-305 and CH-310) manufactured by AOKI OIL INDUSTRIAL, polyoxyethylene stearyl ether (a stearyl alcohol ethylene oxide adduct) (BLAUNON SR-705, SR-707, SR-715, SR-720, SR-730, and SR-750) manufactured by AOKI OIL INDUSTRIAL, randomly polymerized polyoxyethylene polyoxypropylene stearyl ether (BLAUNON SA-50/50 1000R and SA-30/70 2000R) manufactured by AOKI OIL INDUSTRIAL, polyoxyethylene methyl ether (Pluriol® A760E) manufactured by BASF, and polyoxyethylene alkyl ether (EMULGEN series) manufactured by KAO. A commercially available product can also be used as polyalkylene oxide. An example is an ethylene oxide/propylene oxide copolymer (Pluronic PE6400) manufactured by BASF.

The fluorine-based surfactant shows an excellent mold release force reducing effect and hence is effective as the internal mold release agent. The blending ratio of the component (c) except the fluorine-based surfactant in the curable composition is preferably 0 mass% or more and 50 mass% or less with respect to the total of the components (a), (b), and (c), that is, the total mass of all the components except the solvent. The blending ratio is more preferably 0.1 mass% or more and 50 mass% or less, and further preferably 0.1 mass% or more and 20 mass% or less. When the blending ratio of the component (c) except the fluorine-based surfactant is 50 mass% or less, a cured film having a mechanical strength to some extent can be obtained.

<Component (d): Solvent>

The curable composition according to this embodiment can contain a solvent as the component (d). The component (d) is not particularly limited as long as it is a solvent that dissolves the components (a), (b), and (c). A favorable solvent is a solvent having a boiling point of 80°C or more and 200°C or less at normal pressure. Examples are an alcohol-based solvent, a ketone-based solvent, an ether-based solvent, an ester-based solvent, and a nitrogen-containing

solvent. As the component (d), it is possible to use one type of a component alone, or to use two or more types of components by combining them.

Examples of the alcohol-based solvent are as follows.

Monoalcohol-based solvents such as methanol, ethanol, n-propanol, isopropanol, n-butanol, iso-butanol, sec-butanol, tert-butanol, n-pentanol, isopentanol, 2-methylbutanol, sec-pentanol, tert-pentanol, 3-methoxybutanol, n-hexanol, 2-methylpentanol, sec-hexanol, 2-ethylbutanol, sec-heptanol, 3-heptanol, n-octanol, 2-ethylhexanol, sec-octanol, n-nonyl alcohol, 2,6-dimethylheptanol-4, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol; and polyalcohol-based solvents such as ethylene glycol, 1,2-prpylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and glycerin.

Examples of the ketone-based solvent are as follows.

Acetone, methylethylketone, methyl-n-propylketone, methyl-n-butyketone, diethylketone, methyl-iso-butylketone, methyl-n-pentylketone, ethyl-n-butylketone, methyl-n-hexylketone, di-iso-butylketone, trimethylnonanon, cyclohexanone, methylcyclohexanone, 2,4-pentanedione, acetonylacetone, diacetone alcohol, acetophenone, and fenthion.

Examples of the ether-based solvent are as follows.

Ethyl ether, iso-propyl ether, n-butyl ether, n-hexyl ether, 2-ethylhexyl ether, ethylene oxide, 1,2-propylene oxide, dioxolane, 4-methyldioxolane, dioxane, dimethyldioxane, 2-methoxyethanol, 2-ethoxyethanol, ethylene glycol diethyl ether, 2-n-butoxyethanol, 2-n-hexoxyethanol, 2-phenoxyethanol, 2-(2-ethylbutoxy)ethanol, ethylene glycol dibutyl ether, diethylene glycol monomethyl ether, diethylene glycol monoethyl ether, diethylene glycol diethyl ether, diethylene glycol mono-n-butyl ether, diethylene glycol di-n-butyl ether, diethylene glycol mono-n-hexyl ether, ethoxy triglycol, tetraethylene glycol di-n-butyl ether, 1-n-butoxy-2-propanol, 1-phenoxy-2-propanol, propylene glycol monomethyl ether, propylene glycol monoethyl ether, propylene glycol monopropyl ether, dipropylene glycol monomethyl ether, dipropylene glycol monoethyl ether, dipropylene glycol monopropyl ether, tripropylene glycol monomethyl ether, tetrahydrofuran, and 2-methyltetrahydrofuran.

Examples of the ester-based solvent are as follows.

Diethyl carbonate, methyl acetate, ethyl acetate, amyl acetate, γ-butyrolactone, γ-valerolactone, n-propyl acetate, iso-propyl acetate, n-butyl acetate, iso-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxy triglycol acetate, ethyl propionate, n-butyl propionate, iso-amyl propionate, diethyl oxalate, di-n-butyl oxalate, methyl lactate, ethyl lactate, n-butyl lactate, n-amyl lactate, diethyl malonate, dimethyl phthalate, and diethyl phthalate.

Examples of the nitrogen-containing solvent are as follows.

N-methylformamide, N,N-dimethylformamide, N,N-diethylformamide, acetoamide, N-methylacetoamide, N,N-dimethylacetoamide, N-methylpropionamide, and N-methylpyrrolidone.

Of the above-described solvents, the ether-based solvent and the ester-based solvent are favorable. Note that an ether-based solvent and an ester-based solvent each having a glycol structure are more favorable from the viewpoint of good film formation properties.

Further favorable examples are as follows.

Propylene glycol monomethyl ether, propylene glycol monoethyl ether, propylene glycol monopropyl ether, propylene glycol monomethyl ether acetate, propylene glycol monoethyl ether acetate, and propylene glycol monopropyl ether acetate.

<Temperature When Blending Curable Composition>

When preparing the curable composition (A) of this embodiment, at least the components (a) and (b) are mixed and dissolved under a predetermined temperature condition. More specifically, mixing and dissolution are performed at 0°C or more and 100°C or less. This is the same when the components (c) and (d) are contained.

<Viscosity of Curable Composition>

The curable composition (A) according to this embodiment is preferably a liquid. This is so because in a mold contact step (to be described later), spread and fill of the curable composition (A) are rapidly completed, that is, the filling time is short.

<Phases of Curable Composition>

The curable composition (A) according to the present invention is a liquid. This is to arrange the droplets of the curable composition (A) on a substrate by an inkjet method or a spin coating method in an arranging step to be described later.

The curable composition (A) in a case where the inkjet method is used in the arranging step of the present invention can be a curable composition (AJ1) containing no solvent (d) or a curable composition (AJ2) containing the solvent (d).

The viscosity of the curable composition (AJ1) is 2 mPa·s or more and 60 mPa·s or less, preferably 5 mPa·s or more and 30 mPa·s or less, and more preferably 5 mPa·s or more and 15 mPa·s or less.

The viscosity of the curable composition (AJ2) is 2 mPa·s or more and 60 mPa·s or less in a state in which the solvent (d) is contained, preferably 5 mPa·s or more and 30 mPa·s or less, and more preferably 5 mPa·s or more and 15 mPa·s or less. The viscosity in a state in which the solvent (d) volatilized from the curable composition (AJ2), that is, the viscosity at 25°C of a mixture of components except for the solvent (d) of the curable composition (AJ2) is 1 mPa·s or more and 10,000 mPa·s or less, preferably 30 mPa·s or more and 1,000 mPa·s or less, more preferably 30 mPa·s or more and 500 mPa·s or less, and further preferably 120 mPa·s or more and 500 mPa·s or less.

If the viscosity of the curable composition (AJ1) or the curable composition (AJ2) containing the solvent (d) is smaller than 2 mPa·s, the discharge property of droplets by the inkjet method becomes unstable. Also, if the viscosity is larger than 60 mPa·s, it is impossible to form droplets having a volume of about 1.0 to 3.0 pL favorable in the present invention.

When the viscosity of the components except for the solvent (d) of the curable composition (AJ2) is set to 1,000 mPa·s or less, spread and filling are quickly completed when bringing the curable composition (AJ2) into contact with the mold. Hence, when the curable composition (AJ2) according to the present invention is used, it is possible to execute imprint processing at high throughput and suppress pattern defects caused by a filling failure. Also, when the viscosity of components except for the solvent (d) of the curable composition (AJ2) is set to 1 mPa·s or more, it is possible to prevent an unnecessary flow of droplets of the curable composition (A) after the solvent (d) volatilized. Furthermore, when bringing the curable composition (AJ2) into contact with the mold, the curable composition (AJ2) hardly flows out from an end portion of the mold.

The viscosity of a curable composition (AS) in a case where the spin coating method is used in the arranging step of the present invention is 1 mPa·s or more and 100 mPa·s or less in a state in which the solvent (d) is contained. The viscosity in a state in which the solvent (d) volatilized from the curable composition (AS), that is, the viscosity at 25°C of a mixture of components except for the solvent (d) of the curable composition (AS) is 1 mPa·s or more and 10,000 mPa·s or less, preferably 30 mPa·s or more and 1,000 mPa·s or less, more preferably 30 mPa·s or more and 500 mPa·s or less, and further preferably 120 mPa·s or more and 500 mPa·s or less.

When the viscosity of the components except for the solvent (d) of the curable composition (AS) is set to 10,000 mPa·s or less, filling is quickly completed when bringing the curable composition (AS) into contact with the mold. Hence, when the curable composition (AS) according to the present invention is used, it is possible to execute imprint processing at high throughput and suppress pattern defects caused by a filling failure. Also, when the viscosity of components except for the solvent (d) of the curable composition (AS) is set to 1 mPa·s or more, it is possible to prevent an unnecessary flow of droplets of the curable composition (AS) after the solvent (d) volatilized. Furthermore, when bringing the curable composition (AS) into contact with the mold, the curable composition (AS) hardly flows out from an end portion of the mold.

<Surface Tension of Curable Composition>

As the surface tension of the curable composition (A) according to this embodiment, the surface tension of the composition containing the components except the solvent (component (d)) at 23°C is preferably 5 mN/m or more and 70 mN/m or less, more preferably 7 mN/m or more and 50 mN/m or less, and further preferably 10 mN/m or more and 40 mN/m or less. When the surface tension is high, for example, 5 mN/m or more, the capillarity strongly acts. Therefore, filling (spread and fill) is completed within a short time when bringing the curable composition (A) into contact with a mold. When the surface tension is 70 mN/m or less, a cured film obtained by curing the curable composition has surface smoothness.

<Contact Angle of Curable Composition>

As the contact angle of the curable composition (A) according to this embodiment, the contact angle of the composition containing the components except the solvent (component (d)) is preferably 0° or more and 90° or less, and particularly preferably 0° or more and 10° or less, with respect to both the substrate surface and the mold surface. If the contact angle is larger than 90°, the capillarity may act in the negative direction (a direction in which the contact interface between the mold and the curable composition is contracted) inside the mold pattern or in the substrate-mold gap, and this

may make filling impossible. As the contact angle decreases, the capillarity acts more strongly, so the filling rate increases.

<Impurities Mixed in Curable Composition>

The curable composition (A) according to this embodiment preferably contains impurities as less as possible. The impurities described herein mean components except the above-described components (a), (b), (c), and (d). Accordingly, the curable composition according to this embodiment is favorably obtained through a refining step. This refining step is favorably, for example, filtration using a filter.

More specifically, when performing filtration using a filter, it is favorable to perform filtration by using, for example, a filter having a pore size of 0.001 μm or more and 5.0 μm or less, after the above-described components (a), (b), and (c) are mixed. It is more favorable to perform filtration using a filter in multiple stages or by repeating the filtration a number of times. Also, a filtrated liquid can be filtrated again. Filtration can also be performed by using filters having different pore sizes. As the filter to be used in filtration, it is possible to use filters made of, for example, a polyethylene resin, a polypropylene resin, a fluorine resin, and a nylon resin, but the filter is not particularly limited. Impurities such as particles mixed in the curable composition can be removed through the refining step as described above. This makes it possible to prevent impurities such as particles from unexpectedly forming concave and convex portions on a cured film obtained by curing the curable composition, and generating pattern defects.

Note that when using the curable composition according to this embodiment in order to manufacture a semiconductor integrated circuit, it is favorable to avoid mixing of an impurity (metal impurity) containing metal atoms in the curable composition as much as possible, so as not to obstruct the operation of the product. In this case, the concentration of the metal impurity contained in the curable composition is preferably 10 ppm or less, and more preferably 100 ppb or less.

[Substrate (Base Material)]

A substrate as a base material as an object on which the curable composition (A) is arranged is a substrate to be processed, and a silicon wafer is normally used. This substrate as a base material can have a layer to be processed on the uppermost surface. As the layer to be processed, for example, an insulating layer containing at least silicon atoms such as an $SiO_2$ layer can be used. Another layer may further be formed under the layer to be processed in the substrate. Also, when using a quartz substrate as this substrate, a replica (mold replica) of a quartz imprint mold can be manufactured. However, this substrate is not limited to a silicon wafer or a quartz substrate. This substrate can also be freely selected from materials known as semiconductor device substrates, for example, aluminum, a titanium-tungsten alloy, an aluminum-silicon alloy, an aluminum-copper-silicon alloy, silicon oxide, and silicon nitride. Note that the surface of the substrate or the layer to be processed to be used can be treated by a surface treatment such as silane coupling treatment, silazane treatment, or deposition of a thin organic film, thereby improving the adhesion to the curable composition (A). As a practical example of the thin organic film to be deposited as the surface treatment, for example, an adhesive layer described in PTL 3 can be used.

[Film Forming Method]

A film forming method according to this embodiment will be described next with reference to the schematic sectional view of Fig. 1. Note that numbers 1 to 4 in Fig. 1 will be shown as [1], [2], [3], and [4] hereinafter. The film forming method according to this embodiment can be performed as a method of forming a film having a pattern (pattern forming method), and can also be performed as a method of forming a film (for example, a flat film) having no pattern (flat film forming method).

A film formed by executing this embodiment as a pattern forming method is preferably a film having a pattern with a size of 1 nm or more and 10 mm or less on the surface, and more preferably a film having a pattern with a size of 10 nm or more and 100 μm or less. Note that a pattern forming technique for making a film having a pattern (uneven structure) with a nanosize (1 nm or more and 100 nm or less) by using light is generally called a photonanoimprint method. The film forming method according to this embodiment can use the photonanoimprint method, but a curable composition (A) may be cured by using another energy (for example, heat or an electromagnetic wave).

A flat film formed by executing this embodiment as a flat film forming method preferably has a height difference of 8 nm or less on the film surface.

The film forming method can include, for example, an arranging step of arranging a curable composition on a base material, a contact step of bringing the curable composition into contact with a film forming region of a mold, a curing step of curing the curable composition, and a separation step of separating the curable composition and the mold. The contact step is executed after the arranging step, the curing step is executed after the contact step, and the separation step is executed after the curing step. The film forming region is a region that comes into contact with the curable composition at

latest at the start of the curing step. When this embodiment is executed as a pattern forming method, the film forming region has a pattern. When this embodiment is executed as a flat film forming method, the film forming region has a flat surface.

<Arranging Step [1]>

In the arranging step, as schematically shown in [1] of Fig. 1, a curable composition (A) 102 can be arranged on a base material 101.

When executing this embodiment as a pattern forming method, an inkjet method or a spin coating method is preferably used as an arranging method. In the arranging step using the inkjet method, droplets of the curable composition (A) 102 are discretely arranged. Fig. 1 shows a case of the inkjet method as a representative example. Note that in the example schematically shown in Fig. 1, the whole region of the lower surface of a mold 107 is the film forming region. The droplets of the curable composition (A) 102 are preferably dropped such that they are densely arranged in a region facing a region of the base material 101 where concave portions forming the pattern of a mold 107 densely exist, and sparsely arranged in a region facing a region of the base material 101 where the concave portions sparsely exist. Consequently, a residual film 110 (to be described later) can be controlled to have a uniform thickness regardless of whether the pattern of the mold 107 is sparse or dense.

When executing this embodiment as a flat film forming method on the base material 101 having unevenness on the surface, an inkjet method is preferably used as an arranging method. The droplets of the curable composition (A) 102 are preferably arranged densely on the concave portions of the base material 101 and sparsely on the convex portions. Consequently, it is possible to form a flat film whose height difference is smaller than on the surface of the substrate 101.

When the inkjet method is used in the arranging step, an index called an average liquid film thickness is defined as shown in Table 2 to define the volume of the curable composition (A) to be arranged. The average liquid film thickness is a value obtained by dividing the volume of the curable composition (A) (except the solvent (d)) arranged in the arranging step by the area of the film forming region of the mold. The volume of the curable composition (A) (except the solvent (d)) is the sum of volumes of droplets of the curable composition (A) (except the solvent (d)). According to this definition, even if the substrate surface has unevenness, the average liquid film thickness can be defined regardless of the uneven state.

If a curable composition containing the solvent (d), like the curable composition (AJ2) or (AS), is applied to this embodiment, after the arranging step and before the contact step, it is possible to perform a baking step of heating the substrate 101 and the curable composition (A), or ventilate the atmospheric gas around the substrate 101, for the purpose of accelerating the volatilization of the solvent (d). Heating is performed at, for example, 30°C or more and 200°C or less, preferably 80°C or more and 150°C or less, and particularly preferably 90°C or more and 110°C or less. The heating time can be 10 sec or more and 3,000 sec or less. The baking step can be performed by using a known heater such as a hotplate or an oven.

<Contact Step [2]>

In the contact step as schematically shown in [3] of Fig. 1, the curable composition (A) 102 and the film forming region of the mold 107 are brought into contact with each other. The contact step includes a step of a changing a state in which the curable composition (A) 102 and the film forming region of the mold 107 are not in contact with each other to a state in which they are in contact with each other, and a step of maintaining the state in which they are in contact with each other. As a consequence, when executing this embodiment as a pattern forming method, the curable composition (A) is filled 106 in the concave portions of fine patterns on the surface of the film forming region of the mold 107, and the liquid forms a liquid film filled in the fine patterns of the mold 107.

When the subsequent curing step includes a photoirradiation step, a mold made of a light-transmitting material can be used as the mold 107 by taking this into consideration. Favorable practical examples of the type of the material forming the mold 107 are a glass material such as soda-lime glass, borosilicate glass, alkali-barium-silicate glass, aluminosilicate glass, synthetic quartz, or fused quartz, PMMA, a photo-transparent resin such as a polycarbonate resin, a fluorine-based polymer, or polydimethylsiloxane, a transparent metal deposition film, and a material made by combining two or more materials described above. Note that when using the photo-transparent resin as the material forming the mold 107, a resin that does not dissolve in components contained in the curable composition (A) can be selected. Quartz is particularly favorable as the material forming the mold 107 because the thermal expansion coefficient is small and pattern distortion is small.

When executing this embodiment as a pattern forming method, a fine pattern formed on the surface of the film forming region of the mold 107 can have a height of, for example, 4 nm or more and 200 nm or less. As the pattern height decreases, it becomes possible to decrease the force of releasing the mold 106 from the cured film of the curable composition, that is, the mold release force in the separation step, and this makes it possible to decrease the number of mold release defects remaining on the side of the mold 107 because the pattern of the curable composition (A) is torn off in the separation step. Also, in some cases, the pattern of the curable composition (A) elastically deforms due to the impact

when the mold 106 is released, and adjacent pattern elements come in contact with each other and adhere to each other or break each other. To avoid these inconveniences, however, it is advantageous to make the height of pattern elements be about twice or less the width of the pattern elements (make the aspect ratio be 2 or less). On the other hand, if the height of pattern elements is too small, the processing accuracy of the substrate 101 may decrease, and the processing depth may decrease.

When executing this embodiment as a flat film forming method, the height difference of the unevenness on the surface of the film forming region of the mold 107 is preferably 4 nm or less. After the contact step of bringing the film forming region of the mold 107 into contact with the curable composition, the curing step [4] and the separation step [5] are executed, and a cured film having a surface conforming to the flat surface of the mold 107 can be formed.

A surface treatment can also be performed on the film forming region of the mold 107 before performing the contact step, in order to improve the releasability of the surface of the mold 107 from the curable composition (A) 102. An example of this surface treatment is to form a mold release agent layer by coating the surface of the mold 107 with a mold release agent. Examples of the mold release agent to be applied on the surface of the mold 107 are a silicon-based mold release agent, a fluorine-based mold release agent, a hydrocarbon-based mold release agent, a polyethylene-based mold release agent, a polypropylene-based mold release agent, a paraffine-based mold release agent, a montane-based mold release agent, and a carnauba-based mold release agent. It is also possible to suitably use a commercially available coating-type mold release agent such as Optool® DSX manufactured by Daikin. Note that it is possible to use one type of a mold release agent alone or two or more types of mold release agents together. Of these mold release agents, fluorine-based and hydrocarbon-based mold release agents are particularly favorable.

In the contact step, the pressure to be applied to the curable composition (A) 102 when bringing the film forming region of the mold 107 into contact with the curable composition (A) 102 is not particularly limited. This pressure can be, for example, 0 MPa or more and 100 MPa or less. The pressure is preferably 0 MPa or more and 50 MPa or less, more preferably 0 MPa or more and 30 MPa or less, and further preferably 0 MPa or more and 20 MPa or less.

The contact step can be performed under the conditions that, for example, a gas (to be referred to as an inner-gap gas hereinafter) exists in the space between the base material 101 and the mold 107 and the solubility coefficient of the inner-gap gas with respect to the curable composition (A) 102 is 0.5 $kg/m^3 \cdot atm$ or more and 10 $kg/m^3 \cdot atm$ or less. If the solubility coefficient is larger than 10 $kg/m^3 \cdot atm$, the dry-etching resistance and/or the mechanical strength of a cured film 109 may lower.

Also, when the solubility coefficient of the inner-gap gas to the curable composition (A) 102 is defined as S [$kg/m^3 \cdot atm$], the diffusion coefficient of the inner-gap gas in the curable composition (A) 102 as D [$m^2/s$], and the average liquid film thickness as T [nm], it is preferable to set $S \cdot D \cdot T$ to $1.75 \times 10^{-9}$ or more and S to 10 or less. Here, S is preferably 0.5 or more. D is preferably $5 \times 10^{-12}$ or more and $1 \times 10^{-8}$ or less. Methods of calculating S and D will be described later.

Practical examples of the inner-gap gas are carbon dioxide, methane, various kinds of fluorocarbon gases, or gas mixtures of two or more of these gases. Carbon dioxide, methane, various kinds of fluorocarbon gases, or gas mixtures of two or more of these gases can also be used by mixing them with a gas not having a high solubility coefficient, such as nitrogen, oxygen, helium, or argon. When using a gas mixture, the diffusion coefficient and solubility coefficient of the gas mixture can be calculated as weighted average values conforming to the molar ratio of each gas. The contact step is performed at a pressure of, for example, 0.0001 atm or more and 10 atm or less. The diffusion coefficients and the solubility coefficients of the above-described various kinds of gases with respect to the curable composition (A) will be described later.

<Curing Step [3]>

In the curing step as shown in [3] of Fig. 1, the curable composition is cured by irradiating the curable composition (A) 102 with light 108 as curing energy, thereby forming a cured film. In the curing step, for example, a layer of the curable composition (A) 102 can be irradiated with light through the mold 107. More specifically, the curable composition (A) filled in the fine pattern of the mold 107 can be irradiated with light through the mold 107. Consequently, the curable composition (A) 102 filled in the fine pattern of the mold 107 s cured and forms the cured film 109.

The light 108 to be emitted can be selected in accordance with the sensitivity wavelength of the curable composition (A) 102. More specifically, the light 108 can properly be selected from ultraviolet light, X-ray, and an electron beam each having a wavelength of 150 nm or more and 400 nm or less. Among them, the light 108 is particularly preferably ultraviolet light. This is so because many compounds commercially available as curing assistants (photopolymerization initiators) have sensitivity to ultraviolet light. Examples of a light source that emits ultraviolet light are a high-pressure mercury lamp, an ultrahigh-pressure mercury lamp, a low-pressure mercury lamp, a Deep-UV lamp, a carbon arc lamp, a metal halide lamp, a xenon lamp, a KrF excimer laser, an ArF excimer laser, and an $F_2$ excimer laser, and the ultrahigh-pressure mercury lamp is particularly favorable. It is possible to use one light source or a plurality of light sources. Light can be emitted to the entire region of the curable composition (A) filled in the fine pattern of the mold, and can also be limitedly emitted to only a partial region thereof. It is also possible to intermittently emit light to the entire region of the substrate a

plurality of times, or to continuously emit light to the entire region of the substrate. Furthermore, a first region can be irradiated with light in a first irradiation process, and a second region different from the first region can be irradiated with light in a second irradiation process.

<Separation Step [4]>

In the separation step as schematically shown in [4] of Fig. 1, the cured film 109 and the mold 107 are separated. For example, when the cured film 109 and the mold 107 are separated, the cured film 109 having a pattern formed by inverting the fine pattern of the mold 107 is obtained in an independent state. In this state, a cured film remains in the concave portions of the cured film 109 having the pattern. This film can be called the residual film 110.

A method of separating the cured film 109 and the mold 107 can be any method provided that the method does not physically break a part of the cured film 109 during the separation, and various conditions and the like are not particularly limited. For example, it is possible to fix the base material 101 and move the mold 107 away from the base material 101. It is also possible to fix the mold 107 and move the base material 101 away from the mold 107. Alternatively, the mold 107 and the cured film 109 can be separated by pulling both of them in exactly opposite directions.

In the pattern forming method that is one form of this embodiment, a repetitive unit (shot) including steps [1] to [4] can be performed repetitively a plurality of times on the same base material. Also, step [1] may be executed continuously for different regions a plurality of times, and a shot including steps [2] to [4] may be executed continuously for the regions that have undergone step [1]. When a spin coating method is used as the arranging method, step [1] can be executed for the entire surface of the base material, and a shot including steps [2] to [4] can be performed repetitively a plurality of times on the same base material. The above-described shot is repeated a plurality of times, thereby obtaining a plurality of desired cured films 109 at desired positions of the base material.

In the flat film forming method that is one form of this embodiment, a repetitive unit (shot) including steps [1] to [4] can be performed repetitively a plurality of times on the same base material. Also, step [1] may be executed continuously for different regions a plurality of times, and a shot including steps [2] to [4] may be executed continuously for the regions that have undergone step [1]. When a spin coating method is used as the arranging method, step [1] can be executed for the entire surface of the base material, and a shot including steps [2] to [4] can be performed repetitively a plurality of times on the same base material. The above-described shot is repeated a plurality of times, thereby obtaining the flat cured film 109 having a surface conforming to the flat surface of the mold 107 at a desired position of the base material.

<<Method of Manufacturing Circuit Board, Electronic Part, and Optical Apparatus>>

The base material 101 (when the base material 101 has a layer to be processed, this layer to be processed) can be processed by using a processing method such as etching by using the cured film 109 having a pattern formed in accordance with the pattern forming method that is a form of this embodiment as a mask. It is also possible to further deposit a layer to be processed on the cured film 109 having the pattern, and transfer the pattern by using a processing method such as etching. A microstructure such as a circuit structure can be formed on the base material 101 by using the cured film 109 having the pattern as described above. An article can be manufactured based on the microstructure formed on the base material 101. It is also possible to form an apparatus including the article, for example, an electronic apparatus such as a display, a camera, or a medical apparatus. The articles are an electric circuit element, a MEMS, a recording element, a sensor, a mold, and the like. Examples of the electric circuit element are, for example, volatile and nonvolatile semiconductor memories such as an SRAM, a DRAM, an MRAM, an SDRAM, an RDRAM, a D-RDRAM, and a flash memory, and semiconductor elements such as an LSI, a system LSI, a CCD, an image sensor, and an FPGA. Examples of the MEMS include a DMD, a microchannel, and an electromechanical conversion element. Examples of the sensor include a magnetic sensor, an optical sensor, and a gyro sensor. The mold includes an imprint mold or the like. Examples of the recording element include an optical disk such as a CD or a DVD, a magnetic disk, a magneto-optical disk, and a magnetic head. The mold includes an imprint mold or the like.

It is also possible to obtain an optical part using the cured film 109 having a pattern as an optical member (including a case where the cured film 109 is used as a member of an optical member). In this case, the optical part can include at least the base material 101, and the cured film 109 having a pattern on the base material 101. Examples of the optical part are a micro lens, a light guide body, a waveguide, an antireflection film, a diffraction grating, a polarizer, a color filter, a light-emitting element, a display, and a solar battery.

A device such as a semiconductor device can also be manufactured by performing a well-known photolithography step such as a nanoimprint lithography (NIL) technique or an extreme ultraviolet exposure technique (EUV) on a flat film formed in accordance with the flat film forming method that is one form of this embodiment. It is also possible to form an apparatus including the device like this, for example, an electronic apparatus such as a display, a camera, or a medical apparatus. Examples of the device are an LSI, a system LSI, a DRAM, an SDRAM, an RDRAM, a D-RDRAM, and a NAND flash.

[Examples]

More practical examples will be explained below in order to supplement the abovementioned embodiments.

<Calculation of Air Bubble Disappearance Time in Pattern Formation>

A time required when a mold came in contact with droplets of a liquid curable composition (A) dropped in the form of a square array on a base material, adjacent droplets collided with each other and formed air bubbles, and the formed air bubbles dissolved in the curable composition (A) and the mold and completely disappeared, was theoretically calculated as will be described below. This time is the air bubble disappearance time. Note that in this example, assume that no gas is dissolved in the base material.

The air bubble disappearance time is the sum of a dynamic spread time and a static spread time. The dynamic spread time is a time required when the mold comes in contact with the curable composition, and adjacent droplets come in contact with each other and form air bubbles by confining a gas (inner-gap gas) in the interfaces between three phases, that is, the mold, the substrate, and the droplets. The static spread time is a time required when the formed air bubbles dissolve in the curable composition (A), the mold, and the underlayer and completely disappear.

The dynamic spread time was calculated by coupling a lubrication equation for columnar droplets of the curable composition (A) and a motion equation of the mold. The lubrication equation was adopted because the spacing between droplets to be applied is about 100 μm and the height of the droplet distribution is on the other of about a few nm to a few μm, that is, the aspect is high, so a change in pressure in the direction of height can be ignored. Also, the droplet was handled as an incompressible fluid because the Reynolds number can be regarded as being sufficiently small. The aforementioned coupled equations have an analysis solution, and a dynamic spread time $T_{DS}$ is:

$$T_{DS} = \frac{\pi(R^4 - R_0^4)}{4V} \frac{3\mu\pi}{4\sigma(\cos\theta_u + \cos\theta_d)} \quad \ldots(1)$$

In this equation, V is the volume of one droplet, R is the half of the spacing between droplets, $R_0$ is the radius of the column of the droplet of the curable composition (A), $\mu$ is the viscosity of the curable composition (A), $\sigma$ is the surface tension, $\theta_u$ is the contact angle between the curable composition (A) and the mold, and $\theta_d$ is the contact angle between the curable composition and the underlayer.

Next, a method of calculating a time Tss required for static spread will be explained. As shown in Fig. 3, at the moment the droplets of the curable composition (A) collide with each other, an air bubble indicated by a blank portion is approximated by a column having a radius $r_g$ and having the same volume, and the calculation region is also approximated by a column having a radius $r_c$ and having the same volume. Under the initial conditions thus made, a time evolution equation of the air bubble volume, a pressure $p_g$, and a height h of the mold can be obtained by coupling a state equation of an ideal gas, an equation of the mass of the gas, a diffusion equation of the gas to the mold, a diffusion equation of the gas to the curable composition (A), an equation representing conservation of the mass of the curable composition (A), a lubrication equation of the curable composition region, and a motion equation of the mold. The equation of the ideal gas is given by:

$$p_g = \rho_g RT \quad \ldots(2)$$

In this equation, $p_g$ is the pressure of the gas, $p_g$ is the density of the gas, R is a gas constant, and T is the temperature. The equation of the mass of the gas is given by:

$$\pi r_g^2 \rho_g = M_g \quad \text{...(3)}$$

In this equation, $M_g$ is the mass of the gas.

The diffusion equation regarding the diffusion of the gas to the mold is given by:

$$\frac{dc_g}{dt} = \mathrm{D_g} \nabla^2 c_g \quad \text{...(4)}$$

In this equation, $C_g$ is the gas concentration of the mold, and $D_g$ is the diffusion coefficient of the gas to the mold. The boundary conditions were that dissolution conforming to Henry's law occurs on only a surface where the mold and an air bubble are in contact with each other, and that no matter exchange occurs from a surface in contact with the curable composition (A).

The diffusion equation regarding the diffusion of the gas to the curable composition (A) is the same as the diffusion equation regarding the diffusion of the gas to the mold. However, the boundary conditions were that dissolution conforming to Henry's law occurs on only a surface where the curable composition (A) and an air bubble are in contact with each other, and that no matter exchange occurs from a surface in contact with the mold or from the circumferential surface of the column in the calculation region. The equation representing conservation of the mass of the curable composition (A) is given by:

$$\mathrm{\rho_r} \pi \left(r_c^2 - r_g^2\right) h = \rho_r V_d = M_r \quad \text{...(5)}$$

In this equation, $\rho_l$ is the density of the curable composition (A), $V_d$ is the volume of the droplet of the curable composition (A), and $M_r$ is the total mass of the curable composition (A2). The lubrication equation of the region of the curable composition (A) is given by:

$$\frac{h^3}{12\mu}\frac{1}{r}\frac{\partial}{\partial r}r\frac{\partial p_r}{\partial r}=\frac{dh}{dt}$$

...(6)

In this equation, μ is the viscosity of the curable composition (A) as described above. The motion equation of the mold is given by:

$$\pi r_c^2 \rho_m h_m \frac{d^2h}{dt^2} = \pi r_g^2 p_g + \int_{\theta=0}^{2\pi}\int_{r=r_g}^{r_c} p_r(r)rdrd\theta$$

...(7)

Letting T be the average liquid film thickness, a condition that the thickness h of the curable composition (A) satisfies the following inequality:

$$\frac{\boldsymbol{h}-\boldsymbol{T}}{\boldsymbol{T}} < \mathbf{10^{-5}}$$

...(8)

was set as the termination condition of the static spread calculation.

<Calculation of Diffusion Coefficient of Gas in Curable Composition>

In this example, the diffusion coefficient of the gas in the curable composition was calculated by using a molecular dynamics calculation with respect to a molecular aggregate containing 10 gas molecules with respect to 500 molecules forming the curable composition (A). In this example, the molecular dynamics calculation was performed by using GROMACS-2016. 4 (Copy right (c) 2001 - 2017, The GROMACS development team at Uppsala University, Stockholm University and the Royal Institute of Technology, Sweden.) The method of the molecular dynamics calculation is described in NPL 3.

In the molecular dynamics calculation, an equilibrium state was sampled by arranging target molecules in a unit lattice on which the periodic boundary condition was imposed, calculating a force acting between atoms contained in each molecule with respect to each time, and calculating the loci of all atoms with respect to time evolution.

To perform the molecular dynamics calculation, it is necessary to previously set a parameter called a force field parameter for defining the interaction between atoms, and the setting method will be described later. The molecular dynamics calculation includes four stages, that is, a compression process, a relaxation process, an equilibration process, and main calculation.

The compression process is performed to form an appropriate molecular aggregate, the equilibration process is performed to lead the calculation system to a thermodynamic equilibrium state, and sampling of the equilibrium state is performed in main calculation. The calculation conditions for use in the compression process are a simulation time of 40 ps, a temperature of 700K, a compression ratio set value of 0.000045, and an atmospheric pressure set value of 10,000 atm,

and the process is constant-temperature, constant-pressure simulation using the Berendsen method. The calculation conditions for use in the equilibration process are a simulation time of 5 ns, a temperature of 300K, a compression ratio set value of 0.000045, and an atmospheric pressure set value of 1 atm, and the process is constant-temperature, constant-pressure simulation using the Berendsen method. The calculation conditions for use in main calculation are a simulation time of 20 ns, a temperature of 300K, a compression ratio set value of 0.000045, and an atmospheric pressure set value of 1 atm, and the process is constant-temperature, constant-pressure simulation using the Berendsen method.

The diffusion coefficient was calculated from the mean square displacement of gas molecules based on the history of molecular motion obtained by the above-described main calculation.

$$D = \frac{< |\vec{x}(t) - \vec{x}(0)|^2 >}{6t} \quad ...(9)$$

The force field parameter includes two types of parameters, that is, an electrostatic force field parameter and a non-electrostatic force field parameter. The following was used for the electrostatic force field parameter. An electric charge to be allocated to each atom, which is obtained by performing electric charge fitting by using a point based on the MERZ-Singh-Killmans scheme with respect to an electrostatic potential calculated by the Kohn-Sham method (an exchange correlation functional is B3LYP), a basic function 6-31g*) as one method of a quantum chemical calculation. More specifically, in this example, the quantum chemical calculations were performed by using the following. Gaussian 09 manufactured by Gaussian (Gaussian 09, Revision C.01, M.J.Frisch, G.W.Trucks, H.B.Schlegel, G.E.Scuseria, M.A.Robb, J.R.Cheeseman, G.Scalmani, VBarone, B.Mennucci, G.A.Petersson, H.Nakatsuji, M.Caricato, X.Li, H.P.Hratchian, A.F.Izmaylov, J.Bloino, G.Zheng, J.L. Sonnenberg, M.Hada, M.Ehara, K.Toyota, R.Fukuda, J.Hasegawa, M.Ishida, T.Nakajima, YHonda, O.Kitao, H.Nakai, T.Vreven, J.A.Montgomery,Jr., J.E.Peralta, F.Ogliaro, M.Bearpark, J.J.Heyd, E.Brothers, K.N.Kudin, VN.Staroverov, T.Keith, R.Kobayashi, J.Normand, K.Raghavachari, A.Rendell, J.C.Burant, S.S.Iyengar, J.Tomasi, M.Cossi, N.Rega, J.M.Millam, M.Klene, J.E.Knox, J.B.Cross, VBakken, C.Adamo, J.Jaramillo, R.Gomperts, R.E.Stratmann, O.Yazyev, A.J.Austin, R.Cammi, C.Pomelli, J.W.Ochterski, R.L.Martin, K.Morokuma, VG.Zakrzewski, G.A.Voth, PSalvador, J.J.Dannenberg, S.Dapprich, A.D.Daniels, O.Farkas, J.B.Foresman, J.VOrtiz, J.Cioslowski, and D.J.Fox, Gaussian, Inc., Wallingford CT, 2010.) The Merz-Singh-Killmans scheme is described in NPLs 4 and 5. As the non-electrostatic force field, general Amber force field (GAFF, NPL 6) generally used for organic molecules was used.

<Method of Experimentally Measuring Filling Time in Pattern Forming Method>

A curable composition (AJ1-1) containing 9.0 parts by weight of isobornyl acrylate (manufactured by KYOEISHA CHEMICAL, product name: IB-XA), 38 parts by weight of benzyl acrylate (manufactured by Osaka Organic Chemical, product name: V#160), 47 parts by weight of neopentyl glycol diacrylate (KYOEISHA CHEMICAL, product name: NP-A), and 3 parts by weight of Lucirin TPO (manufactured by BASF) was prepared.

In a 26 × 33 mm range on a silicon substrate, droplets of 3.25 pL of a curable composition (AJ1-1) were dropped evenly in a square array with a 140 μm long side, and a blank mold (to be referred to as a mold hereinafter) made of quartz was brought into contact with the curable composition.

The spread behavior of the droplets of the curable composition (AJ1-1), that is, the reduction/disappearance behavior of air bubbles confined in the three-phase interface of mold/substrate/curable composition (AJ1-1) was observed, through the mold, using an optical microscope with a magnification of x5, time until the air bubbles disappear was measured, and time until the air bubbles disappear after the contact between the curable composition and the mold was measured as the air bubble disappearance time.

In a helium atmosphere (inner-gap gas = helium), the air bubble disappearance time was 2.7 sec. In an air atmosphere (inner-gap gas = air), the air bubbles did not disappear even after the elapse of 24 sec. In a carbon dioxide atmosphere (inner-gap gas = carbon dioxide), the air bubble disappearance time was longer by 2.67 times as compared to the helium atmosphere.

<Liquid Physical Property of Curable Composition Used in Pattern Forming Method>

To theoretically calculate the air bubble disappearance time, the viscosity of the curable composition (A), the surface tension, the contact angle to the substrate, and the contact angle to the mold were measured, and a result shown in Table 1 was obtained.

[Table 1]

| | |
|---|---|
| Viscosity of Curable Composition [mPa·s] | 5.6 |
| Surface Tension of Curable Composition | 31 |
| Contact Angle of Curable Composition to Substrate [°] | 0 |
| Contact Angle of Curable Composition to Mold [°] | 0 |

<Example of Theoretical Calculation of Air Bubble Disappearance Time>

Table 2 summarizes the diffusion coefficients and the solubility coefficients of the gases (helium, carbon dioxide, and oxygen) in the curable composition (A) and the mold, which are necessary for the theoretical calculation of the air bubble disappearance time.

Table 2

| | Helium | Carbon dioxide | Oxygen |
|---|---|---|---|
| Solubility coefficient in the silicon substrate [$kg/m^3 \cdot atm$] | 0 | 0 | 0 |
| Diffusion coefficient in the silicon substrate [$m^2/s$] | 0 | 0 | 0 |
| Solubility coefficient in the mold [$kg/m^3 \cdot atm$] | 0.0027 | 0 | 0 |
| Diffusion coefficient in the mold [$m^2/s$] | $1.2 \times 10^{-12}$ | 0 | 0 |
| Solubility coefficient in the curable composition [$kg/m^3 \cdot atm$] | 0.004 | 1.8 | 0.126 |
| Diffusion coefficient in the curable composition [$m^2/s$] | $5.0 \times 10^{-9}$ | $5.0 \times 10^{-11}$ | $2.5 \times 10^{-10}$ |

The basis of the physical values shown in Table 2 will be described below.

All the solubility coefficients and the diffusion coefficients of helium and carbon dioxide to the silicon substrate were set to zero. This is based on a known fact that a gas hardly passes through a silicon crystal.

Known values were used as the diffusion coefficient and the solubility coefficient of helium in the mold.

All the diffusion coefficients and the solubility coefficients of carbon dioxide and oxygen in the mold were set to zero. This is based on a known fact that carbon dioxide and oxygen hardly pass through the mold, as compared to helium.

As for the diffusion coefficients of helium, carbon dioxide, and oxygen to the curable composition (A), calculation values obtained, by the above-described molecular dynamics calculation, from the mean square displacement of gas molecules in a case where isobornyl acrylate as one of the components of the curable composition (A) was used as the solvent were used.

As for the solubility coefficient of helium to the curable composition (A), a value that makes the calculation value of the air bubble disappearance time corresponding to an average liquid film thickness of 28 nm match the above-described actually measured value (2.7 sec), as indicated by Comparative Example 1 shown in Table 3 to be described later, was employed.

As for the solubility coefficient of carbon dioxide to the curable composition (A), a value that makes the calculation value of the air bubble disappearance time corresponding to an average liquid film thickness of 28 nm match the above-described actually measured value (7.2 sec), as indicated by Comparative Example 2 shown in Table 3 to be described later, was employed.

A known value was used as the solubility coefficient of oxygen to the curable composition (A).

[Comparative Example 1, Comparative Example 2, Comparative Example 3, Comparative Example 4, Comparative Example 5, Comparative Example 6, Comparative Example 7, Comparative Example 8, Comparative Example 9, Example 1, Example 2, and Example 3]

In the pattern forming method, helium and carbon dioxide were used as ambient gases (inner-gap gases), and

the average liquid film thickness was set to 28 nm, 50 nm, 60 nm, 70 nm, 100 nm, and 200 nm. Various kinds of coefficients shown in Tables 1 and 2 were input, and time until 0.7 pl of air bubbles, which were generated when 3.25 pL of droplets of the curable composition (A) came into contact with each other and confined in the three-phase interface of mold/substrate/curable composition (A), disappear was calculated. The diameter of a droplet at the start was set to 100 $\mu$m. The mold thickness was 1 mm. The calculation results and actually measured values of the air bubble disappearance time are shown in Table 3.

[Table 3]

| | Ambient gas | Average liquid film thickness [nm] | Theoretical air bubble disappearance time [s] | Measured air bubble disappearance time [s] |
|---|---|---|---|---|
| Comparative Example 1 | Helium | 28 | 2.7 | 2.7 |
| Comparative Example 2 | Carbon dioxide | 28 | 7.3 | 7.2 |
| Comparative Example 3 | Helium | 50 | 4.4 | no data |
| Comparative Example 4 | Carbon dioxide | 50 | 7.0 | no data |
| Comparative Example 5 | Helium | 60 | 5.9 | no data |
| Comparative Example 6 | Carbon dioxide | 60 | 6.9 | no data |
| Comparative Example 7 | Helium | 70 | 102 | no data |
| Example 1 | Carbon dioxide | 70 | 6.8 | no data |
| Comparative Example 8 | Helium | 100 | > 14 | no data |
| Example 2 | Carbon dioxide | 100 | 6.6 | no data |
| Comparative Example 9 | Helium | 200 | > 15 | no data |
| Example 3 | Carbon dioxide | 200 | 6.3 | no data |

From the results of Comparative Examples 1, 2, 3, 4, 5, and 6, it was confirmed, by the theoretical calculation, that when the curable composition (A) was used, and the average liquid film thickness was 60 nm or less, the air bubble disappearance time in the carbon dioxide atmosphere (inner-gap gas = carbon dioxide) was longer than that in the helium atmosphere. On the other hand, from the results of Comparative Examples 7, 8, and 9 and Examples 1, 2, and 3, it was confirmed, by the theoretical calculation, that when the curable composition (A) was used, and the average liquid film thickness was 70 nm or more, the air bubble disappearance time in the carbon dioxide atmosphere (inner-gap gas = carbon dioxide) was shorter than that in the helium atmosphere.

From the results of Comparative Examples 1, 3, 5, 7, 8, and 9, it was confirmed, by the theoretical calculation, that when a curable composition (A2-1) was used, in the helium atmosphere, the thicker the average liquid film thickness was, the longer the air bubble disappearance time was. On the other hand, in Comparative Examples 2, 4, and 6 and Examples 1, 2, and 3, it was confirmed, by the theoretical calculation, that when the curable composition (A) was used, in the carbon dioxide atmosphere, the thicker the average liquid film thickness was, the shorter the air bubble disappearance time was. The qualitative behavior of the air bubble disappearance time with respect to the average liquid film thickness changes between the helium atmosphere and the carbon dioxide atmosphere probably because of the difference of the solubility to the curable composition (A) between helium and carbon dioxide. In general, when the average liquid film thickness is increased, an effect of making the air bubble disappearance time long due to a decrease of the capillary force and an effect of making the air bubble disappearance time short due to an increase of the dissolution volume of the ambient gas contend with each other. Depending on which one of the two contending effects is dominant, whether the air bubble disappearance time becomes short or long along with the increase of the average liquid film thickness is determined. That is, in a case of carbon dioxide, since the solubility to the curable composition (A) is large, the effect of increasing the dissolution volume of the ambient gas by increasing the average liquid film thickness exceeds the effect of decreasing the capillary force. Hence, the thicker the film thickness is, the shorter the air bubble disappearance time is. On the other hand, in a case of helium, since the solubility to the curable composition (A) is small, the effect of decreasing the capillary force by increasing the average liquid film thickness exceeds the effect of increasing the dissolution volume of the ambient gas. Hence, the thicker the average liquid film thickness is, the longer the air bubble disappearance time is.

If the average liquid film thickness is less than 70 nm, helium is more advantageous than carbon dioxide. This is because helium can be diffused into the mold, but carbon dioxide cannot be diffused into the mold. If the average liquid film thickness is 70 nm or more, carbon dioxide is more advantageous than helium. This is because the effect of increasing the

dissolution volume to the curable composition (A) exceeds the effect of diffusion to the mold.

If the average liquid film thickness exceeds 100 μm, it may be difficult to execute the arranging step of arranging the curable composition (A) on the substrate. Hence, the average liquid film thickness is preferably 100 μm or less. However, the average liquid film thickness may exceed 100 μm if the curable composition (A) can be arranged on the substrate even if the average liquid film thickness exceeds 100 μm.

[Comparative Example 10, Example 4, Example 5, Example 6, Example 7, Example 8, Example 9]

In the pattern forming method, the ambient gas (inner-gap gas) was set to oxygen or a gas mixture of oxygen and carbon dioxide, and the average liquid film thickness was set to 70 nm. Then, the time until 0.7 pl of air bubbles, which were generated when 3.25 pL of droplets of the curable composition (A) came into contact with each other and confined in the three-phase interface of mold/substrate/curable composition (A), disappear was calculated. As the input values of the diffusion coefficient and the solubility coefficient, weighted average values according to the molar ratio of each gas were used. The diameter of a droplet at the start was set to 100 μm. The mold thickens was set to 1 mm. The calculation results of the air bubble disappearance time are shown in Table 4.

Table 4

| | Ambient gas | Average liquid film thickness [nm] | Theoretical air bubble disappearance time [s] | Measured air bubble disappearance time [s] |
|---|---|---|---|---|
| Comparative Example 10 | Oxygen 100% | 70 | > 12 | no data |
| Example 4 | Carbon dioxide 10% : Oxygen 90% | 70 | 8.7 | no data |
| Example 5 | Carbon dioxide 25% : Oxygen 75% | 70 | 5.3 | no data |
| Example 6 | Carbon dioxide 50% : Oxygen 50% | 70 | 4.1 | no data |
| Example 7 | Carbon dioxide 80% : Oxygen 20% | 70 | 4.6 | no data |
| Example 8 | Carbon dioxide 90% : Oxygen 10% | 70 | 5.3 | no data |
| Example 9 | Carbon dioxide 95% : Oxygen 5% | 70 | 5.9 | no data |

From the results of Comparative Examples 7 and 10 and Examples 4, 5, 6, 7, 8, and 9, it was confirmed, by the theoretical calculation, that when the average liquid film thickness of the curable composition (A) was 70 nm, the air bubble disappearance time under the gas mixture atmosphere of oxygen and carbon dioxide in which the molar ratio of carbon dioxide was 10% or more was shorter than that in the helium atmosphere. Here, Examples 4 to 9 are examples in which the ambient gas contains carbon dioxide in a molar ratio of 10% or more and oxygen in a molar ratio of 5% or more and 90% or less. Under such a gas mixture atmosphere, the air bubble disappearance time is shorter than in the helium atmosphere.

An article manufacturing method of manufacturing an article by using the abovementioned film forming method or pattern forming method will be explained below. A cured film or the pattern of a cured product formed by the abovementioned film forming method or pattern forming method is used permanently for at least some of various kinds of articles or temporarily when manufacturing various kinds of articles. The articles are an electric circuit element, an optical element, a MEMS, a recording element, a sensor, a mold, and the like. Examples of the electric circuit element are volatile and nonvolatile semiconductor memories such as a DRAM, an SRAM, a flash memory, and an MRAM and semiconductor elements such as an LSI, a CCD, an image sensor, and an FPGA. Examples of the optical element include a microlens, a light guide, a waveguide, an antireflection film, a diffraction grating, a polarizing element, a color filter, a light emitting element, a display, and a solar cell. Examples of the MEMS include a DMD, a microchannel, and an electromechanical conversion element. Examples of the recording element include an optical disk such as a CD or a DVD, a magnetic disk, a magneto-optical disk, and a magnetic head. Examples of the sensor include a magnetic sensor, an optical sensor, and a gyro sensor. The mold includes an imprint mold or the like.

The pattern of the cured product is directly used as at least some of the constituent members of the above-described articles or used temporarily as a resist mask. After etching or ion implantation is performed in the substrate processing step, the resist mask is removed.

An article manufacturing method in which an imprint apparatus forms a pattern on a substrate, processes the substrate on which the pattern is formed, and manufactures an article from the processed substrate will be described next. As shown Fig. 4A, a substrate 1z such as a silicon wafer with a processed material 2z such as an insulator formed on the surface is prepared. Next, an imprint material 3z is applied to the surface of the processed material 2z by an inkjet method or the like. A state in which the imprint material 3z is applied as a plurality of droplets onto the substrate is shown here.

As shown in Fig. 4B, a side of a mold 4z for imprint with a concave-convex pattern is directed toward and made to face the imprint material 3z on the substrate. As shown in Fig. 4C, the substrate 1 to which the imprint material 3z is applied is brought into contact with the mold 4z, and a pressure is applied. The gap between the mold 4z and the processed material 2z is filled with the imprint material 3z. In this state, when the imprint material 3z is irradiated with light as energy for curing via the mold 4z, the imprint material 3z is cured.

As shown in Fig. 4D, after the imprint material 3z is cured, the mold 4z is separated from the substrate 1z, and the pattern of the cured product of the imprint material 3z is formed on the substrate 1z. In the pattern of the cured product, the concave portion of the mold corresponds to the convex portion of the cured product, and the convex portion of the mold corresponds to the concave portion of the cured product. That is, the concave-convex pattern of the mold 4z is transferred to the imprint material 3z.

As shown in Fig. 4E, when etching is performed using the pattern of the cured product as an etching resistant mask, a portion of the surface of the processed material 2z where the cured product does not exist or remains thin is removed to form a groove 5z. As shown in Fig. 4F, when the pattern of the cured product is removed, an article with the grooves 5z formed in the surface of the processed material 2z can be obtained. Here, the pattern of the cured product is removed. However, instead of removing the pattern of the cured product after the process, it may be used as, for example, an interlayer dielectric film included in a semiconductor element or the like, that is, a constituent member of an article.

Another article manufacturing method will be described next. As shown Fig. 5A, a substrate 1y such as silica glass is prepared. Next, an imprint material 3y is applied to the surface of the substrate 1y by an inkjet method or the like. A layer of another material such as a metal or a metal compound may be provided on the surface of the substrate 1y.

As shown in Fig. 5B, a side of a mold 4y for imprint with a concave-convex pattern is directed toward and made to face the imprint material 3y on the substrate. As shown in Fig. 5C, the substrate 1y to which the imprint material 3y is applied is brought into contact with the mold 4y, and a pressure is applied. The gap between the mold 4y and the substrate 1y is filled with the imprint material 3y. In this state, when the imprint material 3 is irradiated with light via the mold 4y, the imprint material 3 is cured.

As shown in Fig. 5D, after the imprint material 3y is cured, the mold 4y is separated from the substrate 1y, and the pattern of the cured product of the imprint material 3y is formed on the substrate 1y. Thus, an article including the pattern of the cured product as a constituent member can be obtained. Note that when the substrate 1y is etched using the pattern of the cured product as a mask in the state shown in Fig. 5D, an article with the concave and convex portions reversed with respect to the mold 4y, for example, an imprint mold can be obtained.

Next, an article manufacturing method of manufacturing an article by using the abovementioned film forming method of forming a film having a flat surface will be explained below. This article manufacturing method includes a film forming step of forming a film on a substrate in accordance with the abovementioned film forming method, and a processing step of processing the substrate on which the film is formed, and manufactures an article from the substrate having undergone these steps. The processing step can include a step of forming a photoresist film on the abovementioned film, a step of forming a latent image on the photoresist film by using an exposure apparatus, and a step of forming a photoresist pattern by developing the latent image. This processing step can further include a step of performing processing (for example, etching or ion implantation) on a substrate 1 by using the photoresist pattern.

The present invention is not limited to the above embodiments and various changes and modifications can be made within the spirit and scope of the present invention. Therefore, to apprise the public of the scope of the present invention, the following claims are made.

This application claims priority from Japanese Patent Application No. 2022-018847 filed February 9, 2022, which is hereby incorporated by reference herein.

## Claims

**1.** A film forming method comprising:

an arranging step of arranging a curable composition on a base material;
a contact step of bringing the curable composition into contact with a film forming region of a mold after the arranging step;

a curing step of curing the curable composition after the contact step; and
a separation step of separating the curable composition and the mold after the curing step,
**characterized in that** in the contact step, a gas that fills a space between the base material and the mold exists,
a solubility coefficient of the gas to the curable composition is not less than 0.5 $kg/m^3 \cdot atm$ and not more than 10 $kg/m^3 \cdot atm$, and
an average liquid film thickness that is a value obtained by dividing a volume of the curable composition by an area of the film forming region is not less than 70 nm.

**2.** The film forming method according to claim 1, **characterized in that** the average liquid film thickness is not more than 100 μm.

**3.** A film forming method comprising:

an arranging step of arranging a curable composition on a base material;
a contact step of bringing the curable composition into contact with a film forming region of a mold after the arranging step;
a curing step of curing the curable composition after the contact step; and
a separation step of separating the curable composition and the mold after the curing step,
**characterized in that** in the contact step, a gas that fills a space between the base material and the mold exists, and
in a case where a solubility coefficient of the gas to the curable composition is defined as S [$kg/m^3 \cdot atm$], a diffusion coefficient as D [$m^2/s$], and an average liquid film thickness that is a value obtained by dividing a volume of the curable composition by an area of the film forming region as T [nm], $S \cdot D \cdot T$ is not less than $1.75 \times 10^{-9}$, and S is not more than 10.

**4.** The film forming method according to claim 3, **characterized in that** S is not less than 0.5.

**5.** The film forming method according to claim 3 or 4, **characterized in that** D is not less than $5 \times 10^{-12}$ and not more than $1 \times 10^{-8}$.

**6.** The film forming method according to any one of claims 1 to 5, **characterized in that** the gas contains carbon dioxide in a molar ratio of not less than 10%.

**7.** The film forming method according to any one of claims 1 to 5, **characterized in that** the gas contains carbon dioxide in a molar ratio of not less than 10% and oxygen in a molar ratio of not less than 5% and not more than 90%.

**8.** The film forming method according to any one of claims 1 to 7, **characterized in that** the film forming region of the mold has a pattern, and a film to which the pattern is transferred is formed by the contact step, the curing step, and the separation step.

**9.** The film forming method according to any one of claims 1 to 7, **characterized in that** the mold has a flat surface, and a film having a surface conforming to the flat surface is formed by the contact step, the curing step, and the separation step.

**10.** The film forming method according to any one of claims 1 to 9, **characterized in that** an uppermost layer of the base material is an insulating layer containing at least silicon atoms.

**11.** An article manufacturing method **characterized by** comprising;

a step of forming a film on a substrate by a film forming method defined in any one of claims 1 to 10; and
a step of obtaining an article by processing the substrate on which the film is formed.

# FIG. 1

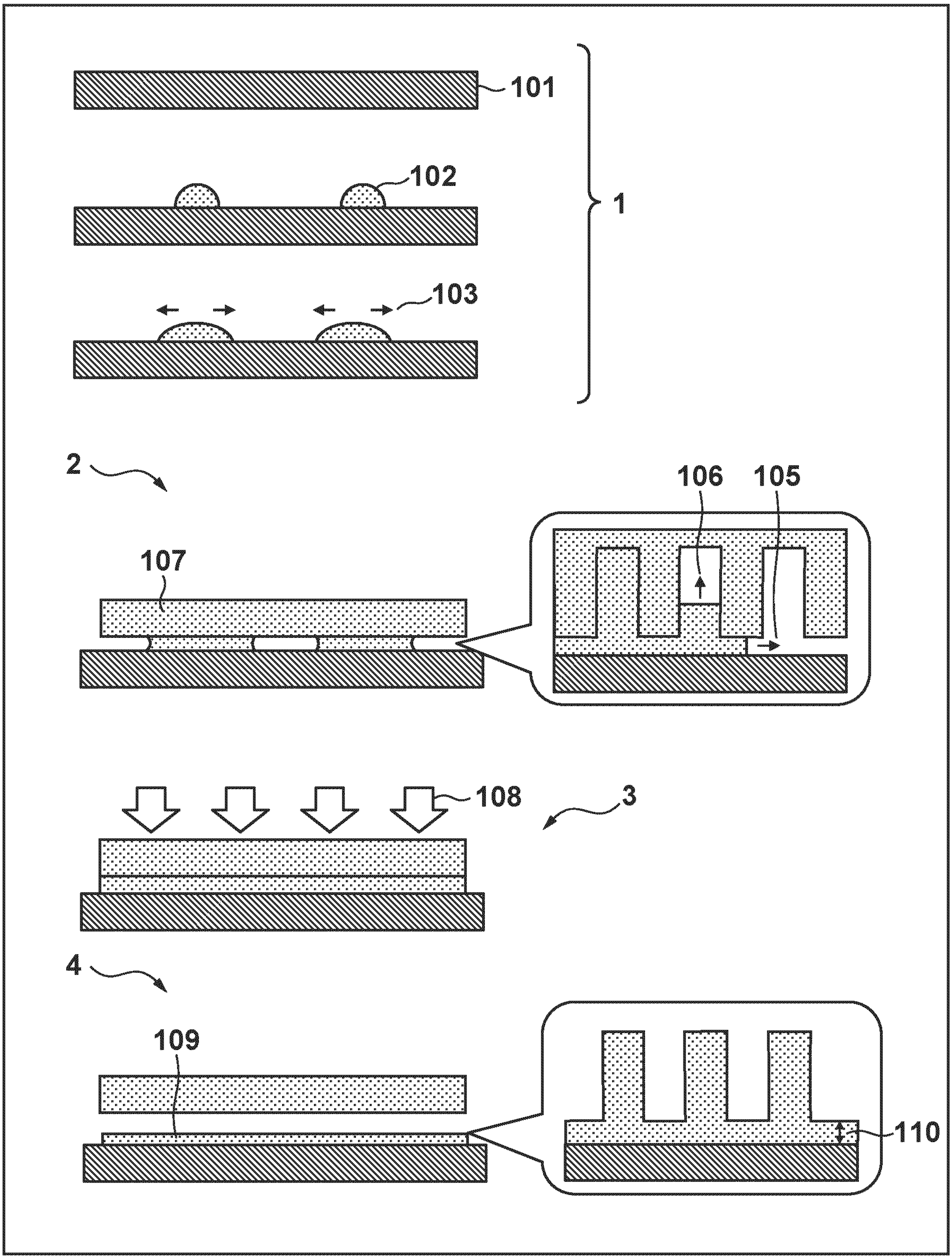

FIG. 2

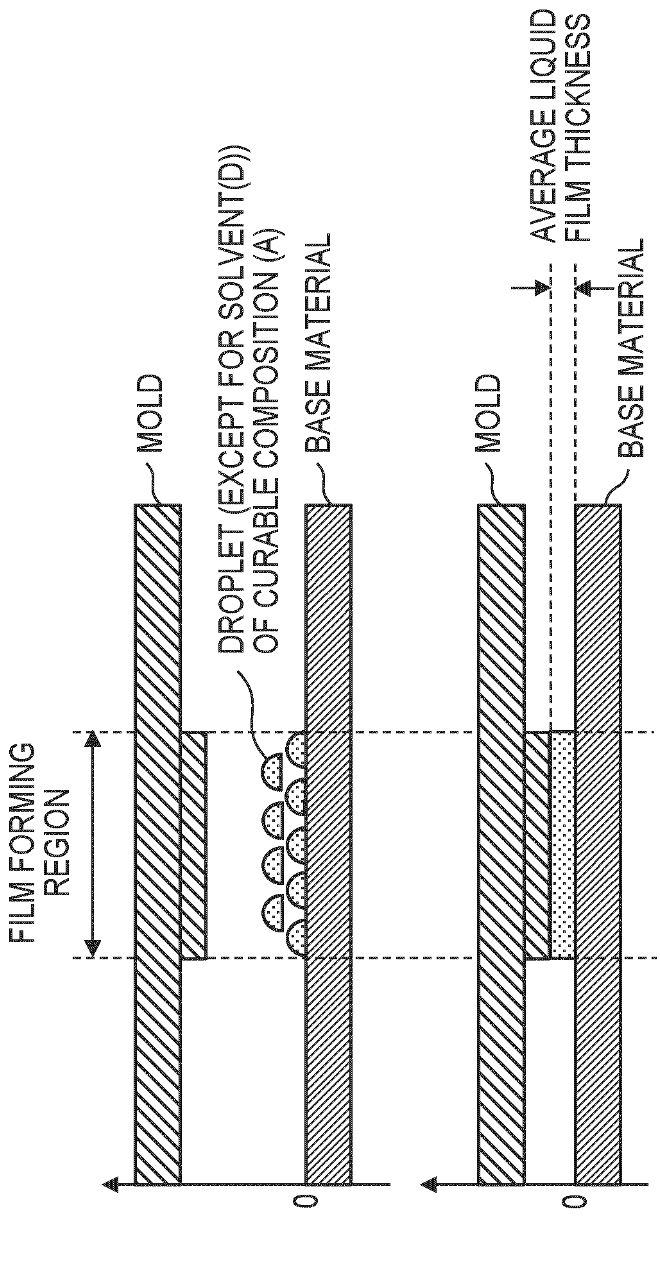
FILM FORMING REGION
MOLD
DROPLET (EXCEPT FOR SOLVENT(D)) OF CURABLE COMPOSITION (A)
BASE MATERIAL
0
MOLD
AVERAGE LIQUID FILM THICKNESS
BASE MATERIAL
0

FIG. 3

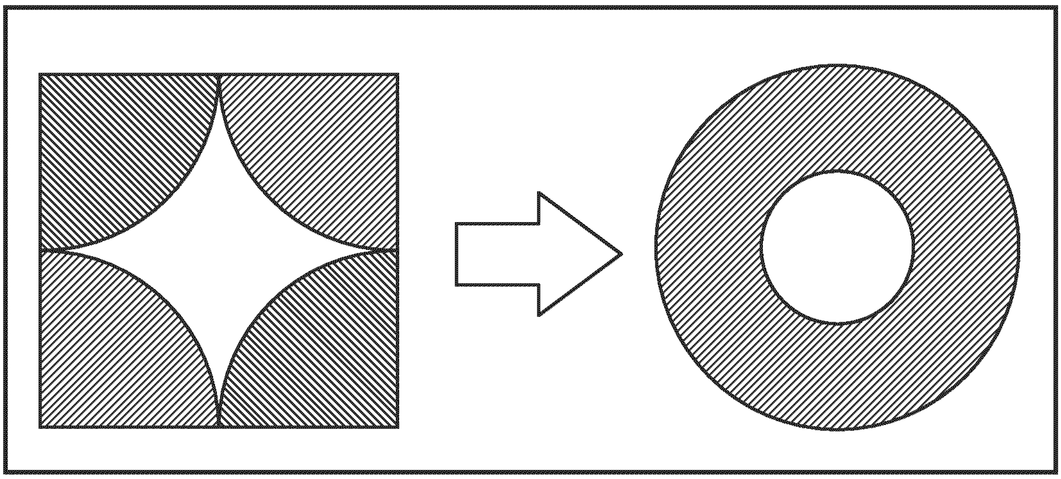

FIG. 4A

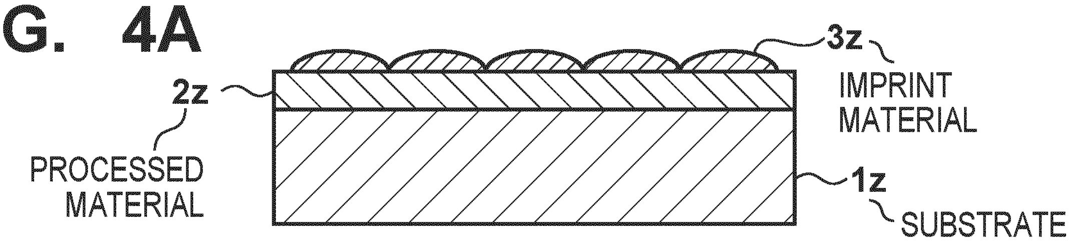


FIG. 4B

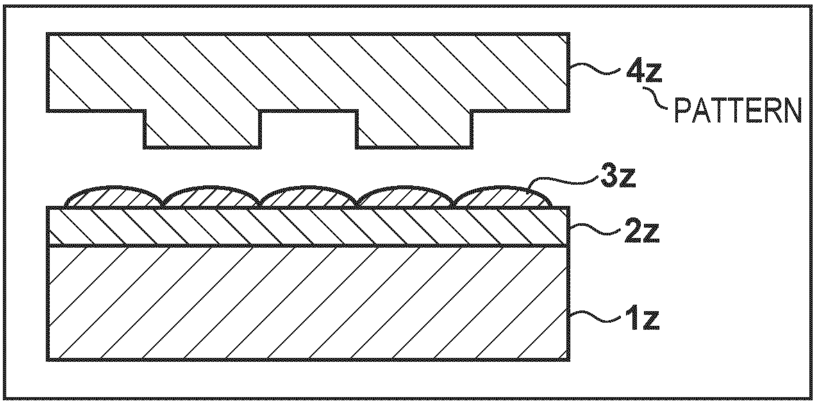


FIG. 4C

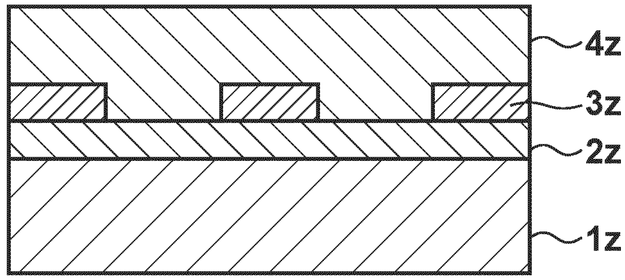


FIG. 4D

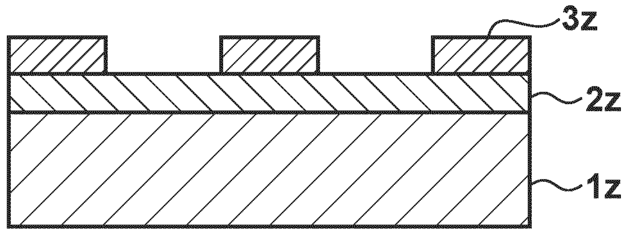


FIG. 4E

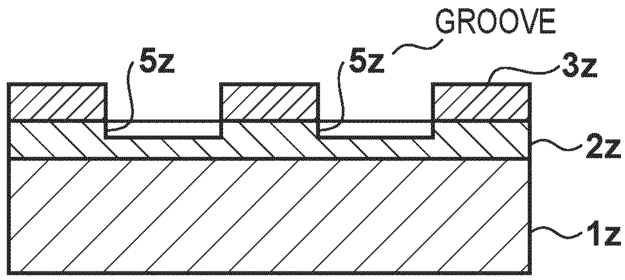


FIG. 4F

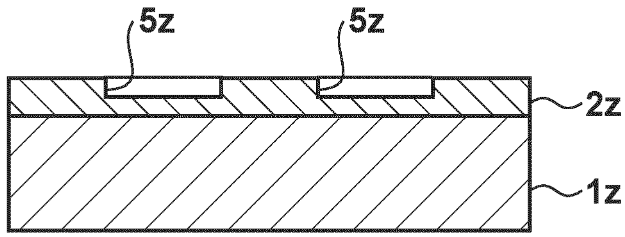

FIG. 5A

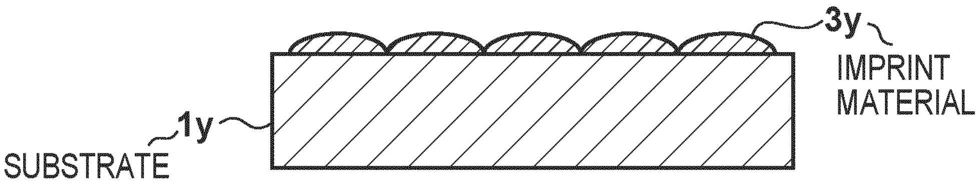


FIG. 5B

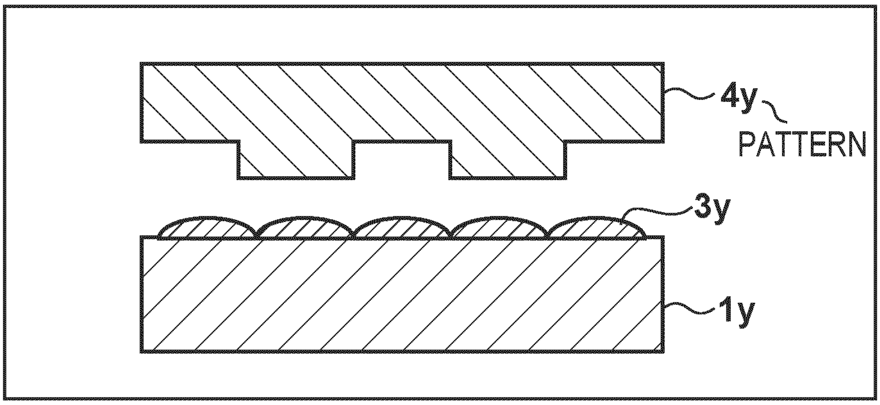


FIG. 5C

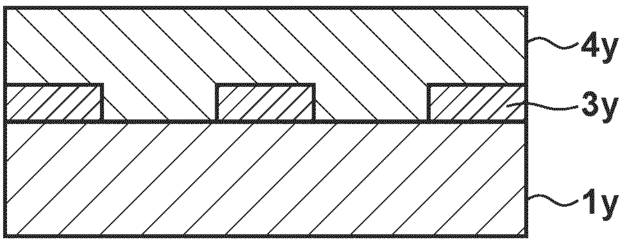


FIG. 5D

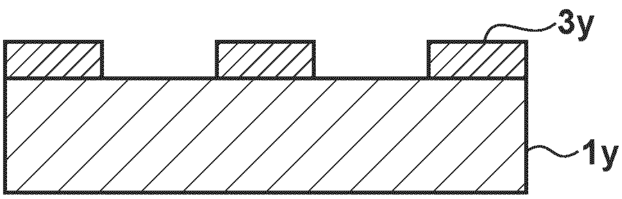

## INTERNATIONAL SEARCH REPORT

International application No.
**PCT/JP2023/000600**

**A. CLASSIFICATION OF SUBJECT MATTER**

***H01L 21/027***(2006.01)i; ***B29C 59/02***(2006.01)i
FI: H01L21/30 502D; B29C59/02 Z

According to International Patent Classification (IPC) or to both national classification and IPC

**B. FIELDS SEARCHED**

Minimum documentation searched (classification system followed by classification symbols)

H01L21/027; H01L21/30; B29C59/02

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2014-196284 A (CANON INC.) 16 October 2014 (2014-10-16) paragraph [0119] | 1-11 |
| A | JP 2015-99899 A (CANON INC.) 28 May 2015 (2015-05-28) entire text, all drawings | 1-11 |
| A | JP 2016-54232 A (CANON INC.) 14 April 2016 (2016-04-14) entire text, all drawings | 1-11 |
| A | JP 2021-89987 A (CANON INC.) 10 June 2021 (2021-06-10) entire text, all drawings | 1-11 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **24 February 2023** | **14 March 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**

International application No.
**PCT/JP2023/000600**

**Box No. III Observations where unity of invention is lacking (Continuation of item 3 of first sheet)**

This International Searching Authority found multiple inventions in this international application, as follows:

The claims are classified into the following two inventions.

(Invention 1) Claims 1-2, and claims 6-11 selectively citing claims 1-2

The invention as in claim 1 is found to have a special technical feature. Accordingly, the invention as in claim 1, claim 2 citing claim 1, and claims 6-11 selectively citing any one of claims 1-2 are classified as invention 1.

(Invention 2) Claims 3-5, and claims 6-11 selectively citing claims 3-5

Claim 3 shares, with claim 1 classified as invention 1, the feature of "a film forming method including: an arrangement step for arranging a curable composition on a base material; a contact step for bringing the curable composition and a film forming region of a mold into contact with each other after the arrangement step; a curing step for curing the curable composition after the contact step; and a separation step for separating the curable composition and the mold after the curing step, the film forming method being characterized in that, in the contact step, gas filling a space between the base material and the mold is present, the solubility coefficient of the gas with respect to the curable composition is S [$kg/m^3$•atm]", and "the average film thickness, which is a value obtained by dividing the volume of the curable composition by the area of the film forming region", and "S is 10 or less". However, it is well known to a person skilled in the art to perform imprinting processing in a helium or carbon dioxide atmosphere, for example, and to use a curable composition such as isobornyl acrylate or benzyl acrylate as the curable composition for imprinting. Further, this feature does not make a contribution over the prior art, and thus cannot be said to be a special technical feature.

Furthermore, there is no other identical or corresponding special technical feature between claim 3 and claim 1.

Additionally, claim 3 does not depend from claim 1. Moreover, claim 3 is not substantially identical to or similarly closely related to any of the claims classified as invention 1.

Therefore, claim 3 cannot be classified as invention 1, and thus claim 3 is classified as invention 2.

Claims 4-5 citing claim 3, and claims 6-11 selectively citing any one of claims 3-5 depend from claim 3, and thus are classified as invention 2.

1. ☑ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☑ No protest accompanied the payment of additional search fees.

Form PCT/ISA/210 (continuation of first sheet) (January 2015)

**INTERNATIONAL SEARCH REPORT**
**Information on patent family members**

International application No.
**PCT/JP2023/000600**

| Patent document cited in search report | Publication date (day/month/year) | Patent family member(s) | Publication date (day/month/year) |
|---|---|---|---|
| JP 2014-196284 A | 16 October 2014 | US 2015/0368433 A1<br>paragraph [0160]<br>WO 2014/136977 A1<br>EP 2941781 A1<br>TW 201443559 A<br>CN 105009256 A<br>KR 10-2015-0121162 A | |
| JP 2015-99899 A | 28 May 2015 | US 2015/0315322 A1<br>entire text, all drawings<br>WO 2014/084395 A1<br>EP 2907156 A1<br>TW 201422698 A<br>CN 104823264 A<br>KR 10-2015-0087403 A | |
| JP 2016-54232 A | 14 April 2016 | (Family: none) | |
| JP 2021-89987 A | 10 June 2021 | US 2021/0173986 A1<br>entire text, all drawings<br>KR 10-2021-0070214 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019140394 A
- US 20200286740 A
- JP 2009503139 A
- JP 2022018847 A


### Non-patent literature cited in the description


- **N. SHIRAISHI**. *Int. J. Microgravity Sci.*, 2014 (31), S5-S12
- *Proc. SPIE*, 2020, 11324-11
- **SUSUMU OKAZAKI**. Basis of Computer Simulation. *KAGAKUDOJIN*, 2000
- **B. H. BESLER** ; **K. M. MERZ JR.** ; **P. A. KOLLMAN**. *J. Comp. Chem.*, 1990, vol. 11, 431
- **U. C. SINGH** ; **P. A. KOLLMAN**. *J. Comp. Chem.*, 1984, vol. 5, 129
- **WANG, J.** ; **WOLF, R. M.** ; **CALDWELL, J. W.** ; **KOLLMAN, P. A.** ; **CASE, D. A.** *J. Comp. Chem.*, 2004, vol. 25, 1157